(19) Europäisches Patentamt
European Patent Office
Office européen des brevets

(11) **EP 4 496 455 A1**

(12) **EUROPEAN PATENT APPLICATION**
published in accordance with Art. 153(4) EPC

(43) Date of publication:
**22.01.2025 Bulletin 2025/04**

(21) Application number: **23895706.2**

(22) Date of filing: **08.03.2023**

(51) International Patent Classification (IPC):
**H10K 59/131** (2023.01)  **H10K 59/127** (2023.01)
**G06F 3/041** (2006.01)

(52) Cooperative Patent Classification (CPC):
**G06F 3/041; H10K 59/127; H10K 59/131;
H10K 71/70**

(86) International application number:
**PCT/CN2023/080321**

(87) International publication number:
**WO 2024/113531 (06.06.2024 Gazette 2024/23)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **01.12.2022 CN 202211533619**

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **LIU, Jia
Beijing 100176 (CN)**
• **HUANG, Yao
Beijing 100176 (CN)**
• **WANG, Rong
Beijing 100176 (CN)**
• **HE, Yi
Beijing 100176 (CN)**
• **YAN, Jun
Beijing 100176 (CN)**
• **GUAN, Hui
Beijing 100176 (CN)**

(74) Representative: **Durán-Corretjer, S.L.P.
Còrsega, 329
(Paseo de Gracia/Diagonal)
08037 Barcelona (ES)**

(54) **DISPLAY PANEL AND DISPLAY APPARATUS**

(57)    A display panel and a display apparatus. The display panel comprises a display substrate. The display substrate comprises: a display area (AA) and a binding area (B1) located on one side of the display area (AA); a plurality of sub-pixels (Pxij) located in the display area (AA); a plurality of data lines located in the display area (AA) and electrically connected to the plurality of sub-pixels (Pxij); and a plurality of binding pin groups (41) located in the binding area (B1), wherein each binding pin group (41) comprises at least one driving pin group (411) and at least one touch pin group (412), and in the plurality of binding pin groups (41), the plurality of driving pin groups (411) are arranged in a first direction, at least one touch pin group (412) is arranged between the plurality of driving pin groups (411) in an interspersed manner, and at least one touch pin group (412) is arranged between every two adjacent driving pin groups (411).

FIG. 11

**Description**

The present application claims priority to the patent application No. 202211533619.X, entitled "Display Substrate and Display Apparatus", filed to the CNIPA on December 01, 2022, the contents of which should be interpreted as being incorporated into the present application by reference.

Technical Field

The present disclosure relates to, but is not limited to, the field of display technologies, and particularly to a display panel and a display apparatus.

Background

An Organic Light Emitting Diode (OLED) display apparatus has ultra-thinness, a large viewing angle, active light emission, high brightness, continuously adjustable color of emitted light, a low cost, a fast response speed, low power consumption, a wide operating temperature range, flexible display, and other advantages, and has gradually become a next generation display technology with great development prospects. According to different driving modes, OLEDs may be classified into two types, a passive matrix (PM) type and an active matrix (AM) type, wherein an AM OLED is a current driving device in which an independent thin film transistor (TFT) is used for controlling each sub-pixel, and each sub-pixel may be continuously and independently driven to emit light.

Summary

The following is a summary of subject matters described herein in detail. This summary is not intended to limit the protection scope of claims.

In a first aspect, an embodiment of the present disclosure provides a display panel, including a display substrate which includes a display region and a bonding region located on one side of the display region; a plurality of sub-pixels located in the display region; a plurality of data lines located in the display region and electrically connected with the plurality of sub-pixels; and a plurality of bonding pin groups located in the bonding region.

A bonding pin group includes at least one drive pin group and at least one touch pin group, and in the plurality of bonding pin groups, a plurality of drive pin groups are arranged in a first direction, at least one touch pin group is interspersed in the plurality of drive pin groups, and at least one touch pin group is arranged between two adjacent drive pin groups, at least part of drive pins of the drive pin groups is configured to be electrically connected with the plurality of data lines, and the at least one touch pin group is configured to be electrically connected with a touch line.

In an exemplary implementation, the display substrate further includes: a bezel region surrounding the display region, which includes the bonding region and is provided with gate drive circuits; at least two of the plurality of bonding pin groups respectively include gate drive circuit pin groups configured to be electrically connected with gate drive circuits.

In an exemplary implementation, in the first direction, a quantity of the at least two bonding pin groups is two, the two bonding pin groups each include a gate drive circuit pin group, and two gate drive circuit pin groups are respectively located in the two bonding pin groups on two sides.

In an exemplary implementation, the plurality of bonding pin groups include n bonding pin groups, a first bonding pin group to an nth bonding pin group are sequentially arranged in the first direction, and n is a positive integer greater than or equal to 2.

The two gate drive circuit pin groups include a first gate drive circuit pin group and a second gate drive circuit pin group, the first gate drive circuit pin group is located in the first bonding pin group, and the second gate drive circuit pin group is located in the nth bonding pin group.

In the first bonding pin group, the first gate drive circuit pin group is located on a side of a drive pin group away from the nth bonding pin group, and the first gate drive circuit pin group and a touch pin group are respectively located on two sides of the drive pin group; in the nth bonding pin group, the second gate drive circuit pin group is located on a side of a drive pin group away from the first bonding pin group, and the second gate drive circuit pin group and a touch pin group are respectively located on two sides of the drive pin group.

In an exemplary implementation, the bonding pin group further includes two power supply pin groups configured to be electrically connected with power supply lines; in the first direction, in a same bonding pin group, the two power supply pin groups are respectively arranged on two sides of the drive pin group, a power supply pin group and a touch pin group on a same side of the drive pin group are arranged in the first direction, and a power supply pin group and a gate drive circuit pin group on a same side of the drive pin group are arranged in the first direction.

In an exemplary implementation, in a same bonding pin group, in the first direction, the power supply pin group located on a same side of the drive pin group include a first power supply pin group and a second power supply pin group, the second power supply pin group is located on a side of the first power supply pin group away from the drive pin group, the first power supply pin group is configured to be electrically connected with a first power supply line, and the second power supply pin group is configured to be electrically connected with a second power supply line.

In an exemplary implementation, in a same bonding pin group, in the first direction, two first power supply pin groups located on two sides of the drive pin group are symmetrical with respect to the drive pin group, and two second power supply pin groups located on two sides of the drive pin group are symmetrical with respect to the drive pin group.

In an exemplary implementation, in the first bonding pin group, in the first direction, on a side of the drive pin group away from the nth bonding pin group, the first gate drive circuit pin group is located on a side of the second power supply pin group away from the first power supply pin group, or between the first power supply pin group and the second power supply pin group, or between the first power supply pin group and the drive pin group;

in the nth bonding pin group, in the first direction, on a side of the drive pin group away from the first bonding pin group, the second gate drive circuit pin group is located on a side of the second power supply pin group away from the first power supply pin group, or between the first power supply pin group and the second power supply pin group, or between the first power supply pin group and the drive pin group.

In an exemplary implementation, in the first direction, in a same bonding pin group, the power supply pin groups and the touch pin group located on a same side of the drive pin group are arranged in the first direction, and the touch pin group is located on a side of the second power supply pin group away from the first power supply pin group, or between the first power supply pin group and the second power supply pin group, or between the drive pin group and the first power supply pin group.

In an exemplary implementation, a touch pin group is arranged between two adjacent drive pin groups, and the touch pin group is located between two second power supply pin groups, or between the first power supply pin group and the second power supply pin group in a same bonding pin group, or between the first power supply pin group and the drive pin group in a same bonding pin group.

In an exemplary implementation, in the first direction, at least one touch pin group is arranged on a side of the first bonding pin group away from the nth bonding pin group, and on the side of the first bonding pin group away from the nth bonding pin group, the at least one touch pin group is located between the first gate drive circuit pin group and the second power supply pin group, or between the first power supply pin group and the second power supply pin group, or between the first power supply pin group and the drive pin group; at least one touch pin group is provided on a side of the nth bonding pin group away from the first bonding pin group; and on the side of the nth bonding pin group away from the first bonding pin group, the at least one touch pin group is located between the second gate drive circuit pin group and the second power supply pin group, or between the first power supply pin group and the second power supply pin group, or between the first power supply pin group and the drive pin group.

In an exemplary implementation, the bonding region includes a bonding pin region and a drive chip region, wherein in a second direction, the drive chip region is located between the display region and the bonding pin region, and the plurality of bonding pin groups are arranged in the bonding pin region; the drive chip region is provided with a plurality of integrated circuit pin groups arranged in the first direction, wherein the plurality of integrated circuit pin groups are configured to be bonded with integrated circuits and electrically connected with the plurality of data lines, and the plurality of drive pin groups are respectively connected with a corresponding plurality of integrated circuit pin groups through pin connection lines; the plurality of bonding pin groups are configured to be electrically connected with the plurality of data lines through the plurality of integrated circuit pin groups, respectively.

In an exemplary implementation, the plurality of integrated circuit pin groups include n integrated circuit pin groups, a first integrated circuit pin group to an nth integrated circuit pin group are sequentially arranged in the first direction and are respectively connected with the first bonding pin group to the nth bonding pin group; the gate drive circuits are configured to be electrically connected with the first integrated circuit pin group and the nth integrated circuit pin group through gate drive circuit signal lines.

In an exemplary implementation, the bezel region includes a first bezel region and a second bezel region located on two sides of the display region in the first direction; the gate drive circuit signal lines includes a first gate drive circuit signal line and a second gate drive circuit signal line, wherein the first gate drive circuit signal line extends from the first bezel region to the bonding region, and the second gate drive circuit signal line extends from the second bezel region to the bonding region; the gate drive circuit includes a first gate drive circuit arranged in the first bezel region and a second gate drive circuit arranged in the second bezel region, the first gate drive circuit is configured to be electrically connected with the first integrated circuit pin group through the first gate drive circuit signal line, and the second gate drive circuits are configured to be electrically connected with the nth integrated circuit pin group through the second gate drive circuit signal line.

In an exemplary implementation, the bonding region is further provided with a first adapter line and a second adapter line, the first adapter line is configured to be connected to the first gate drive circuit signal line and the first gate drive circuit pin group, and the second adapter line is configured to be connected to the second gate drive circuit signal line and the second gate drive circuit pin group.

In an exemplary implementation, the bonding region further includes a plurality of test circuit groups located in the bonding region and arranged in the first direction, and in a second direction, the plurality of test circuit groups are located between the plurality of bonding pin groups and the display region; the plurality of test circuit groups are electrically connected with the plurality of data lines, each test circuit group is configured to be connected with at least one bonding pin group during a test phase; the first direction intersects with the second direction.

In a second aspect, an embodiment of the present disclosure provides a display panel, including:

a display substrate including a display region and a bonding region located on one side of the display region.
a plurality of sub-pixels located in the display region;
a plurality of data lines located in the display region and electrically connected with the plurality of sub-pixels; and
a plurality of bonding pin groups located in the bonding region.

A bonding pin group includes at least one drive pin group, and in the plurality of bonding pin groups, a plurality of drive pin groups are arranged in a first direction, two bonding pin groups of the plurality of bonding pin groups located on two sides each include a gate drive circuit pin group, at least part of drive pins of the drive pin groups is configured to be electrically connected with the plurality of data lines, and the gate drive circuit pin groups are configured to be electrically connected with gate drive circuit signal lines.

In an exemplary implementation, the plurality of bonding pin groups include n bonding pin groups, a first bonding pin group to an nth bonding pin group are sequentially arranged in the first direction, and n being a positive integer greater than or equal to 2; a bonding pin group also includes at least one touch pin group, the at least one touch pin group is interspersed in n drive pin groups, at least one touch pin group is arranged between two adjacent drive pin groups, and the at least one touch pin group is configured to be electrically connected with a touch line; two gate drive circuit pin groups comprise a first gate drive circuit pin group and a second gate drive circuit pin group, wherein the first gate drive circuit pin group is located in the first bonding pin group, and the second gate drive circuit pin group is located in the nth bonding pin group; in the first bonding pin group, the first gate drive circuit pin group is located on a side of the drive pin group away from the nth bonding pin group; in the nth bonding pin group, the second gate drive circuit pin group is located on a side of the drive pin group away from the first bonding pin group.

In an exemplary implementation, in the first direction, on a side of the first gate drive circuit pin group away from the nth bonding pin group no touch pin group is provided; and on a side of the second gate drive circuit pin group away from the first bonding pin group no touch pin group is provided.

In an exemplary implementation, the bonding region includes a bonding pin region and a drive chip region, and in a second direction, the drive chip region is located between the display region and the bonding pin region, the plurality of bonding pin groups being provided in the bonding pin region;

the drive chip region is provided with n integrated circuit pin groups arranged in the first direction, a first integrated circuit pin group to an nth integrated circuit pin group are arranged sequentially in the first direction and are respectively connected with the first bonding pin group to the nth bonding pin group, the n integrated circuit pin groups are configured to be respectively bonded with n integrated circuits and electrically connected with the plurality of data lines, and the n drive pin groups are respectively connected with corresponding n integrated circuit pin groups through pin connection lines; the n bonding pin groups are configured to be electrically connected to the plurality of data lines through the n integrated circuit pin groups, respectively.

In an exemplary implementation, the display substrate further includes: a bezel region surrounding the display region, the bezel region includes the bonding region, and a first bezel region and a second bezel region located on two sides of the display region in the first direction, the bezel region is provided with gate drive circuits and gate drive circuit signal lines; a gate drive circuit signal line includes a first gate drive circuit signal line and a second gate drive circuit signal line, wherein the first gate drive circuit signal line extends from the first bezel region to the bonding region, and the second gate drive circuit signal line extends from the second bezel region to the bonding region.

Herein, the gate drive circuit includes a first gate drive circuit arranged in the first bezel region and a second gate drive circuit arranged in the second bezel region, the first gate drive circuit is configured to be electrically connected with the first integrated circuit pin group through the first gate drive circuit signal line, and the second gate drive circuits are configured to be electrically connected with the nth integrated circuit pin group through the second gate drive circuit signal line.

In an exemplary implementation, the bonding region is further provided with a first adapter line configured to be connected with the first gate drive circuit signal line and the first gate drive circuit pin group, and a second adapter line configured to be connected with the second gate drive circuit signal line and the second gate drive circuit pin group.

In an exemplary implementation, the bonding pin group further includes two power supply pin groups configured to be electrically connected with power supply lines; in the first direction, in a same bonding pin group, the two power supply pin groups are respectively arranged on two sides of the drive pin group, and a power supply pin group and a gate drive circuit pin group on a same side of the drive pin group are arranged in the first direction.

In an exemplary implementation, in a same bonding pin group, in the first direction, the power supply pin group located on a same side of the drive pin group includes a first power supply pin group and a second power supply pin group, the second power supply pin group is located on a side of the first power supply pin group away from the drive pin group, wherein the first power supply pin group is configured to be electrically connected with a first power supply line, and the second power supply pin group is configured to be electrically connected with a second power supply line.

In an exemplary implementation, in the first bonding pin group, in the first direction, on a side of the drive pin group away from the nth bonding pin group, the first gate drive circuit pin group is located on a side of the second power supply pin group away from the first power supply pin group, or between the first power supply pin group and the second power supply pin group, or between the first power supply pin group and the drive pin group; in the nth bonding pin group, in the first direction, on a side of the drive pin group away from the first bonding pin group, the second gate drive circuit pin group is located on a side of the second power supply pin group away from the first power supply pin group, or between the first power supply pin group and the second power supply pin group, or between the first power supply pin group and the drive pin group.

In a third aspect, an embodiment of the present disclosure also provides a display apparatus including the display panel described in any of the above embodiments.

Other aspects of the present disclosure may be comprehended after the drawings and the detailed description are read and understood.

Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shape and size of each component in the drawings do not reflect actual scales, but are only intended to schematically illustrate contents of the present disclosure.

FIG. 1 is a schematic diagram of a structure of a display apparatus.
FIG. 2 is a schematic diagram of a planar structure of a display substrate.
FIG. 3 is a schematic diagram of a cross-sectional structure of a display substrate.
FIG. 4 is a schematic diagram of an equivalent circuit of a pixel drive circuit.
FIG. 5 is a working timing diagram of a pixel drive circuit.
FIG. 6 is a schematic diagram of a structure of a display panel.
FIG. 7 is a schematic diagram of a structure of a bonding region in a display panel.
FIG. 8 is a schematic diagram of a structure of a display panel.
FIG. 9 is a schematic diagram of a structure of a display panel.
FIG. 10 is a schematic diagram of a structure of a display panel.
FIG. 11 is a schematic diagram of a structure of a display panel provided in an embodiment of the present disclosure.
FIG. 12 is a schematic diagram of a structure of a display panel provided in an exemplary embodiment of the present disclosure.
FIG. 13a is a schematic diagram of a structure of a display panel provided in an exemplary embodiment of the present disclosure.
FIG. 13b is a schematic diagram of a structure of a display panel provided in an exemplary embodiment of the present disclosure.
FIG. 14 is a schematic diagram of a structure of a display panel provided in an exemplary embodiment of the present disclosure.
FIG. 15 is a schematic diagram of a structure of a display panel provided in an exemplary embodiment of the present disclosure.
FIG. 16 is a schematic diagram of a structure of a display panel provided in an exemplary embodiment of the present disclosure.
FIG. 17 is a schematic diagram of a structure of a display panel provided in an exemplary embodiment of the present disclosure.
FIG. 18 is a schematic diagram of a structure of a display panel provided in an exemplary embodiment of the present disclosure.
FIG. 19 is a schematic diagram of a structure of a display panel provided in an exemplary embodiment of the present disclosure.
FIG. 20 is an enlarged schematic diagram of a structure of a first bonding pin group provided in an exemplary embodiment of the present disclosure.
FIG. 21 is a schematic diagram of a structure of a display panel provided in an embodiment of the present disclosure.

FIG. 22 is a schematic diagram of a structure of a display panel provided in an embodiment of the present disclosure.

FIG. 23 is a schematic diagram of a structure of a display panel provided in an exemplary embodiment of the present disclosure.

FIG. 24 is a schematic diagram of a structure of a display panel provided in an exemplary embodiment of the present disclosure.

FIG. 25 is a schematic diagram showing an arrangement of traces of a flexible circuit board in a display panel provided in an exemplary embodiment of the present disclosure.

FIG. 26 is a schematic diagram showing an arrangement of traces of a flexible circuit board in a display panel provided in an exemplary embodiment of the present disclosure.

FIG. 27 is a schematic diagram showing an arrangement of traces of a flexible circuit board in a display panel provided in an exemplary embodiment of the present disclosure.

Detailed Description

Embodiments of the present disclosure will be described in detail hereinafter with reference to the drawings. Implementations may be implemented in multiple different forms. Those of ordinary skills in the art can easily understand such a fact that implementations and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. In order to keep following description of the embodiments of the present disclosure clear and concise, detailed description for part of known functions and known components are omitted in the present disclosure. The drawings in the embodiments of the present disclosure relate only to the structures involved in the embodiments of the present disclosure, and other structures may refer to conventional designs.

Unless otherwise defined, technical terms or scientific terms used in the embodiments of the present disclosure shall have common meanings as construed by those of ordinary skills in the art to which the present disclosure pertains. "First", "second", and similar terms used in the embodiments of the present disclosure do not represent any order, quantity, or importance, but are only used for distinguishing different components. "Include", "contain", or a similar word means that an element or object appearing before the word covers an element or object listed after the word and equivalent thereof and does not exclude other elements or objects.

In the specification, for convenience, expressions "middle", "above", "below", "front", "back", "vertical", "horizontal", "top", "bottom", "inside", "outside", etc., indicating directional or positional relationships are used to illustrate positional relationships between the composition elements by referring to drawings, not to indicate or imply that involved devices or elements are required to have specific orientations and be structured and operated with the specific orientations but only to easily and simply describe the present application, and thus should not be understood as limitations on the present invention. The positional relationships between the constituent elements may be changed as appropriate according to a direction in which each constituent element is described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, or may be a detachable connection, or an integrally connection; it may be a mechanical connection, or may be an electrical connection; it may be a direct connection, or may be an indirect connection through middleware, or may be an internal connection between two elements. Those of ordinary skilled in the art will understand the specific meanings of the above terms in the present invention according to specific situations.

In the present disclosure, a transistor refers to an element including at least three terminals, i.e., a gate, a drain, and a source. A transistor has a channel region between a drain electrode (or referred to as a drain electrode terminal, a drain connection region, or a drain) and a source electrode (or referred to as a source electrode terminal, a source connection region, or a source), and a current can flow through the drain electrode, the channel region, and the source electrode. In the present disclosure, the channel region refers to a region through which a current mainly flows.

In the present disclosure, a first electrode may be a drain electrode while a second electrode may be a source electrode, or a first electrode may be a source electrode while a second electrode may be a drain electrode. Functions of the "source electrode" and the "drain electrode" are sometimes interchangeable with each other in a situation in which transistors with opposite polarities are used or a current direction changes during working of a circuit. Therefore, the "source electrode" and the "drain electrode" are interchangeable in the present disclosure. The gate electrode may also be called a control electrode.

In the present disclosure, "electric connection" includes a case where constituent elements are connected through an element with a certain electrical effect. An "element with a certain electrical effect" is not particularly limited as long as electrical signals between the connected constituent elements may be sent and received. For example, the "element having a certain electrical effect" may be an electrode or wiring, or a switch element (such as a transistor), or other functional elements, such as a resistor, an inductor, a capacitor, or the like.

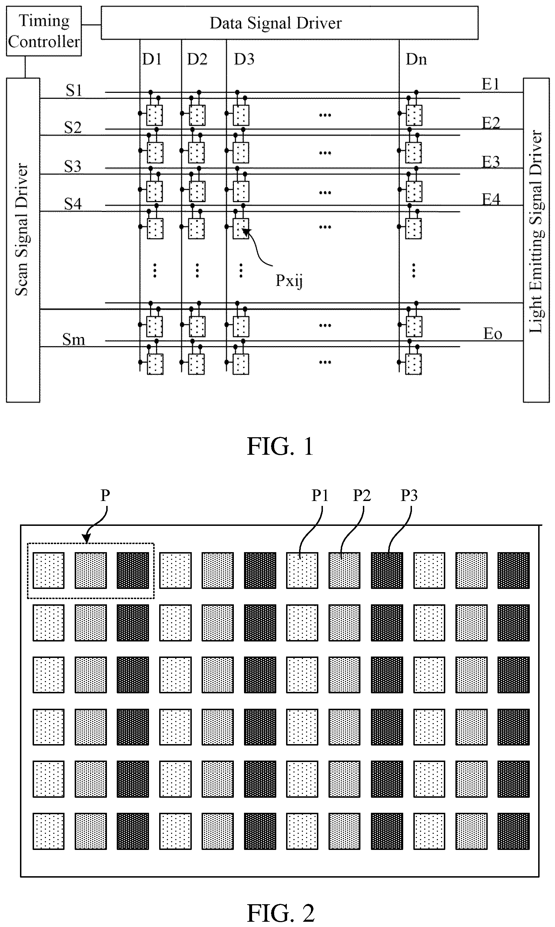

FIG. 1 is a schematic diagram of a structure of a display apparatus. A display substrate may include a timing controller, a data signal driver, a scan signal driver, a light emitting signal driver, and a pixel array. The timing controller is connected with the data signal driver, the scan signal driver, and the light emitting signal driver, respectively, the data signal driver is connected with a plurality of data signal lines (D1 to Dn) respectively, the scan signal driver is connected with a plurality of scan signal lines (S1 to Sm) respectively, and the light emitting signal driver is connected with a plurality of light emitting signal lines (E1 to Eo) respectively. The pixel array may include a plurality of sub-pixels Pxij, wherein i and j may be natural numbers, at least one sub-pixel Pxij may include a circuit unit and a light emitting device connected to the circuit unit, and the circuit unit may include at least one scan signal line, at least one data signal line, at least one light emitting signal line, and a pixel drive circuit. In an exemplary implementation, the timing controller may provide a gray scale value and a control signal suitable for a specification of the data signal driver to the data signal driver, may provide a clock signal, and a scan start signal, etc., suitable for a specification of the scan signal driver to the scan signal driver, and may provide a clock signal, and an emission stop signal, etc., suitable for a specification of the light emitting signal driver to the light emitting signal driver. The data signal driver may generate data voltages to be provided to data signal lines D1, D2, D3, ..., and Dn using the gray scale value and the control signal received from the timing controller. For example, the data signal driver may sample the gray scale value using a clock signal and apply a data voltage corresponding to the gray scale value to the data signal lines D1 to Dn by taking a pixel row as a unit, wherein n may be a natural number. The scan signal driver may generate scan signals to be provided to scan signal lines S1, S2, S3, ..., and Sm by receiving a clock signal, a scan start signal, and the like from the timing controller. For example, the scan signal driver may sequentially provide scan signals with turning-on-level pulses to the scan signal lines S1 to Sm. For example, the scan signal driver may be constructed in a form of a shift register, and generate the scan signals in a mode of sequentially transmitting the scan start signal provided in a form of turning-on-level pulses to a next-stage circuit under controlling of the clock signal, wherein m may be a natural number. The light emitting signal driver may generate an emission signal to be provided to emitting signal lines E1, E2, E3, ..., and Eo by receiving the clock signal, the transmission stop signal, and the like from the timing controller. For example, the light emitting signal driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

FIG. 2 is a schematic diagram of a planar structure of a display substrate. As shown in FIG. 2, the display substrate may include a plurality of pixel units P arranged in a matrix, at least one of the plurality of pixel units P includes a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 each include a pixel drive circuit and a light emitting device. Pixel drive circuits in the first sub-pixel P1, the second sub-pixel P2, and the third sub-pixel P3 are connected with a scan signal line, a data signal line, and a light emitting signal line respectively. A pixel drive circuit is configured to receive a data voltage transmitted by the data signal line under control of the scan signal line and the light emitting signal line, and output a corresponding current to the light emitting device. Light emitting devices in the first sub-pixel P1, the second sub-pixel P2, and the third sub-pixel P3 are respectively connected with the pixel drive circuit of the sub-pixel in which the light emitting device is located, and the light emitting device is configured to emit light with a corresponding brightness in response to a current outputted by the pixel drive circuit of the sub-pixel in which the light emitting device is located.

In an exemplary implementation, a pixel unit P may include a red (R) sub-pixel, a green (G) sub-pixel, and a blue (B) sub-pixel. In an exemplary implementation, a sub-pixel in the pixel unit may be in a shape of a rectangle, a rhombus, a pentagon, or a hexagon. Three sub-pixels may be arranged side by side horizontally, side by side vertically, or in a manner like a Chinese character "品", which is not limited in the present disclosure.

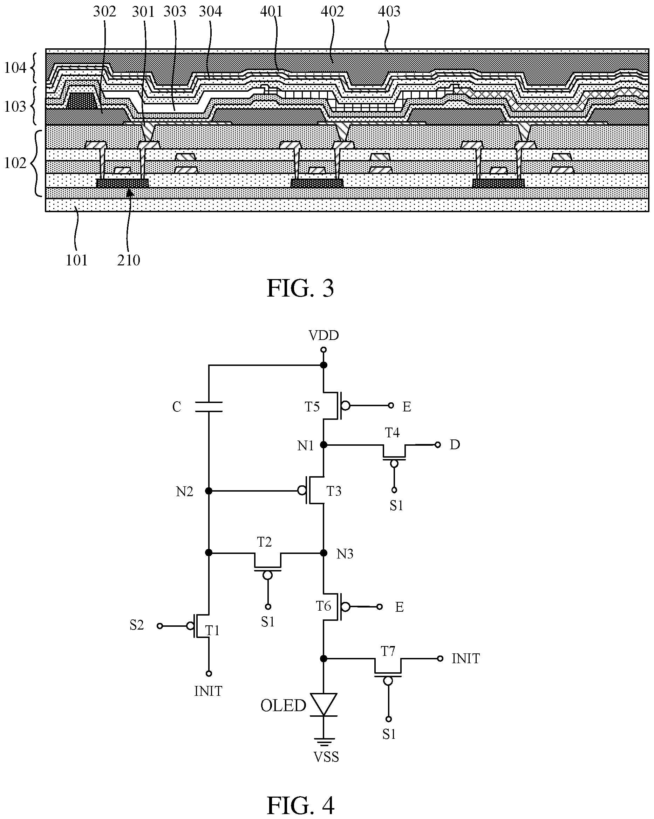

FIG. 3 is a schematic diagram of a cross-sectional structure of a display substrate, which illustrates a structure of three sub-pixels of an OLED display substrate. As shown in FIG. 3, on a plane perpendicular to the display substrate, the display substrate may include a drive circuit layer 102 disposed on a base substrate 101, a light emitting structure layer 103 disposed on a side of the drive circuit layer 102 away from the base substrate 101, and an encapsulation layer 104 disposed on a side of the light emitting structure layer 103 away from the base substrate 101. In some possible implementations, the display substrate may include another film layer, such as a post spacer, which is not limited in the present disclosure.

In an exemplary implementation, the base substrate 101 may be a flexible base substrate, or may be a rigid base substrate. The drive circuit layer 102 of each sub-pixel may include a plurality of transistors and a storage capacitor constituting a pixel drive circuit. The light emitting structure layer 103 may include an anode 301, a pixel definition layer 302, an organic light emitting layer 303 and a cathode 304. The anode 301 is connected to a drain electrode of a driving transistor 210 through a via, the organic light emitting layer 303 is connected to the anode 301, and the cathode 304 is connected to the organic light emitting layer 303. The organic light emitting layer 303 emits light of a corresponding color under the driving of the anode 301 and the cathode 304. The encapsulation layer 104 may include a first encapsulation layer 401, a second encapsulation layer 402, and a third encapsulation layer 403 that are stacked. The first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 so as to prevent external water vapor from entering the light-emitting structure layer 103.

In an exemplary implementation, the organic emitting layer 303 may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL) which are stacked. In an exemplary implementation, hole injection layers of all sub-pixels may be connected together to be a common layer, electron injection layers of all the sub-pixels may be connected together to be a common layer, hole transport layers of all the sub-pixels may be connected together to be a common layer, electron transport layers of all the sub-pixels may be connected together to be a common layer, hole block layers of all the sub-pixels may be connected together to be a common layer, emitting layers of adjacent sub-pixels may be overlapped slightly or may be isolated, and electron block layers of adjacent sub-pixels may be overlapped slightly or may be isolated.

In an exemplary implementation, the pixel drive circuit may be of a structure of 3T1C, 4T1C, 5T1C, 5T2C, 6T1C, or 7T1C. FIG. 4 is a schematic diagram of an equivalent circuit of a pixel drive circuit. As shown in FIG. 4, the pixel drive circuit may include seven transistors (a first transistor T1 to a seventh transistor T7) and one storage capacitor C, and the pixel drive circuit may be connected with seven signal lines (a data signal line D, a first scan signal line S1, a second scan signal line S2, a light emitting signal line E, an initial signal line INIT, a first power supply line VDD, and a second power supply line VSS).

In an exemplary implementation, the pixel drive circuit may include a first node N1, a second node N2, and a third node N3. The first node N1 is connected with a first electrode of the third transistor T3, a second electrode of the fourth transistor T4, and a second electrode of the fifth transistor T5 respectively. The second node N2 is connected with a second electrode of the first transistor T1, a first electrode of the second transistor T2, a control electrode of the third transistor T3, and a second terminal of the storage capacitor C respectively. The third node N3 is connected with a second electrode of the second transistor T2, a second electrode of the third transistor T3, and a first electrode of the sixth transistor T6 respectively.

In an exemplary implementation, a first end of the storage capacitor C is connected with the first power supply line VDD, and the second end of the storage capacitor C is connected with the second node N2, i.e., the second end of the storage capacitor C is connected with the control electrode of the third transistor T3.

The control electrode of the first transistor T1 is connected with the second scan signal line S2, the first electrode of the first transistor T1 is connected with the initial signal line INIT, and the second electrode of the first transistor is connected with the second node N2. When a scan signal with an on-level is applied to the second scan signal line S2, the first transistor T1 transmits an initialization voltage to the control electrode of the third transistor T3, so as to initialize a charge amount of the control electrode of the third transistor T3.

A control electrode of the second transistor T2 is connected with the first scan signal line S1, a first electrode of the second transistor T2 is connected with the second node N2, and a second electrode of the second transistor T2 is connected with the third node N3. When a scan signal with an on level is applied to the first scan signal line S1, the second transistor T2 enables the control electrode of the third transistor T3 to be connected with the second electrode of the third transistor T3.

A control electrode of the third transistor T3 is connected with the second node N2, i.e., the control electrode of the third transistor T3 is connected with the second end of the storage capacitor C, a first electrode of the third transistor T3 is connected with the first node N1, and the second electrode of the third transistor T3 is connected with the third node N3. The third transistor T3 may be referred to as a drive transistor, and the third transistor T3 determines an amount of a drive current flowing between the first power supply line VDD and the second power supply line VSS according to a potential difference between the control electrode and the first electrode of the third transistor T3.

A control electrode of the fourth transistor T4 is connected with the first scan signal line S1, a first electrode of the fourth transistor T4 is connected with the data signal line D, and a second electrode of the fourth transistor T4 is connected with the first node N1. The fourth transistor T4 may be referred to as a switching transistor, a scan transistor, etc., and the fourth transistor T4 enables a data voltage of the data signal line D to be input into the pixel drive circuit when a scan signal with an on level is applied to the first scan signal line S 1.

A control electrode of the fifth transistor T5 is connected with the light emitting signal line E, a first electrode of the fifth transistor T5 is connected with the first power supply line VDD, and a second electrode of the fifth transistor T5 is connected with the first node N1. A control electrode of the sixth transistor T6 is connected with the light emitting signal line E, a first electrode of the sixth transistor T6 is connected with the third node N3, and a second electrode of the sixth transistor T6 is connected with a first electrode of a light emitting device. The fifth transistor T5 and the sixth transistor T6 may be referred to as light emitting transistors. When a light emitting signal with an on level is applied to the light emitting signal line E, the fifth transistor T5 and the sixth transistor T6 enable the light emitting device to emit light by forming a drive current path between the first power supply line VDD and the second power supply line VSS.

The control electrode of the seventh transistor T7 is connected with the first scan signal line S1, the first electrode of the seventh transistor T7 is connected with the initial signal line INIT, and the second electrode of the seventh transistor T7 is connected with the first electrode of the light emitting device. When a scan signal with an on-level is applied to the first scan signal line S1, the seventh transistor T7 transmits an initialization voltage to the first electrode of the light emitting device so as to initialize a charge amount accumulated in the first electrode of the light emitting device or release a charge amount accumulated in the first electrode of the light emitting device.

In an exemplary implementation, the second electrode of the light emitting device is connected to the second power supply line VSS, a signal of the second power supply line VSS is a low-level signal, and a signal of the first power supply line VDD is a high-level signal continuously provided. The first scan signal line S1 is a scan signal line in a pixel drive circuit in a current display row, and the second scan signal line S2 is a scan signal line in a pixel drive circuit in a previous display row, that is, for the n-th display row, the first scan signal line S1 is S(n), and the second scan signal line S2 is S(n-1). The second scan signal line S2 in the pixel drive circuit in the current display row and the first scan signal line S1 in the pixel drive circuit in the previous display row are the same signal line, such that signal lines of a display panel can be reduced, so as to achieve a narrow bezel of the display panel.

In an exemplary implementation, the first transistor T1 to the seventh transistor T7 may be P-type transistors, or may be N-type transistors. Use of a same type of transistors in a pixel drive circuit may simplify a process flow, reduce a process difficulty of a display panel, and improve a product yield. In some possible implementations, the first transistor T1 to the seventh transistor T7 may include a P-type transistor and an N-type transistor.

In an exemplary implementation, the first scan signal line S1, the second scan signal line S2, the light emitting signal line E, and the initial signal line INIT extend along a horizontal direction, and the second power supply line VSS, the first power supply line VDD, and the data signal line D extend along a vertical direction.

In an exemplary implementation, the light emitting device may be an Organic Light Emitting Diode (OLED) including a first electrode (anode), an organic emitting layer, and a second electrode (cathode) that are stacked.

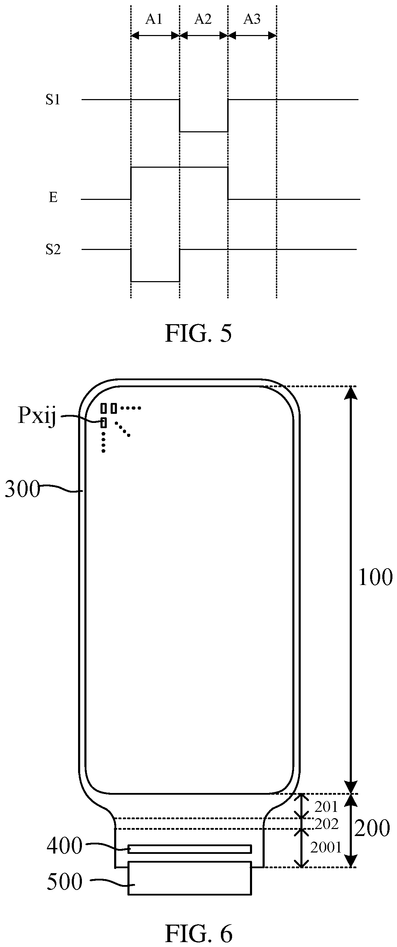

FIG. 5 is a working timing diagram of a pixel drive circuit. An exemplary implementation will be described below through a working process of the pixel drive circuit illustrated in FIG. 4. The pixel drive circuit in FIG. 4 includes seven transistors (a first transistor T1 to a seventh transistor T7), one storage capacitor C, and seven signal lines (a data signal line D, a first scan signal line S1, a second scan signal line S2, a light emitting signal line E, an initial signal line INIT, a first power supply line VDD, and a second power supply line VSS), wherein all of the seven transistors are P-type transistors.

In an exemplary implementation, the working process of the pixel drive circuit may include following stages.

In a first stage A1, referred to as a reset stage, a signal of the second scan signal line S2 is a low-level signal, and signals of the first scan signal line S1 and the light emitting signal line E are high-level signals. The signal of the second scan signal line S2 is the low-level signal, so that the first transistor T1 is turned on, and a signal of the initial signal line INIT is provided to the second node N2 to initialize the storage capacitor C to clear an original data voltage in the storage capacitor. The signals of the first scan signal line S1 and the light emitting signal line E are the high-level signals, so that the second transistor T2, the fourth transistor T4, the fifth transistor T5, the sixth transistor T6, and the seventh transistor T7 are turned off. An OLED does not emit light in this stage.

In a second stage A2, referred to as a data writing stage or a threshold compensation stage, a signal of the first scan signal line S1 is a low-level signal, signals of the second scan signal line S2 and the light emitting signal line E are high-level signals, and the data signal line D outputs a data voltage. In this stage, the second end of the storage capacitor C is at a low level, so the third transistor T3 is turned on. The signal of the first scan signal line S1 is the low-level signal, so that the second transistor T2, the fourth transistor T4, and the seventh transistor T7 are turned on. The second transistor T2 and the fourth transistor T4 are turned on, so that the data voltage output by the data signal line D is provided to the second node N2 through the first node N1, the turned-on third transistor T3, the third node N3, and the turned-on second transistor T2, and the storage capacitor C is charged with a difference between the data voltage output by the data signal line D and a threshold voltage of the third transistor T3. A voltage at the second end (the second node N2) of the storage capacitor C is Vd-|Vth|, wherein Vd is the data voltage output by the data signal line D, and Vth is the threshold voltage of the third transistor T3. The seventh transistor T7 is turned on, so that an initialization voltage of the initial signal line INIT is provided to a first electrode of the OLED to initialize (reset) the first electrode of the OLED and clear a pre-stored voltage therein, thereby completing initialization and ensuring that the OLED does not emit light. A signal of the second scan signal line S2 is a high-level signal, so that the first transistor T1 is turned off. A signal of the light emitting signal line E is a high-level signal, so that the fifth transistor T5 and the sixth transistor T6 are turned off.

In a third stage A3, referred to as a light emitting stage, a signal of the light emitting signal line E is a low-level signal, and signals of the first scan signal line S1 and the second scan signal line S2 are high-level signals. The signal of the light emitting signal line E is the low-level signal, so that the fifth transistor T5 and the sixth transistor T6 are turned on, and a power voltage output by the first power supply line VDD provides a drive voltage to the first electrode of the OLED through the turned-on fifth transistor T5, the third transistor T3, and the sixth transistor T6 to drive the OLED to emit light.

In a drive process of the pixel drive circuit, a drive current flowing through the third transistor T3 (drive transistor) is determined by a voltage difference between a gate electrode and the first electrode of the third transistor T3. The voltage of the second node N2 is Vdata-IVthl, so the drive current of the third transistor T3 is as follows.

$$I = K*(Vgs-Vth)2 = K*[(Vdd-Vd+|Vthl|)-Vth]2 = K*[(Vdd-Vd)]2$$

Herein, I is the drive current flowing through the third transistor T3, i.e., a drive current for driving the OLED, K is a constant, Vgs is the voltage difference between the gate electrode and the first electrode of the third transistor T3, Vth is the threshold voltage of the third transistor T3, Vd is the data voltage output by the data signal line D, and Vdd is the power voltage output by the first power supply line VDD.

FIG. 6 is a schematic diagram of a structure of a display panel. As shown in FIG. 6, the display panel may include a display region 100, a bonding region 200 located on one side of the display region 100, and a bezel region 300 located on the other sides of the display region 100. The display region 100 may include a plurality of sub-pixels Pxij arranged regularly, and a sub-pixel may include a pixel drive circuit and a light emitting device. The bonding region 200 may include a bonding circuit connecting signal lines to an external drive apparatus, and the bezel region 300 may include gate drive circuits, and second power supply lines VSS for transmitting voltage signals to the plurality of sub-pixels.

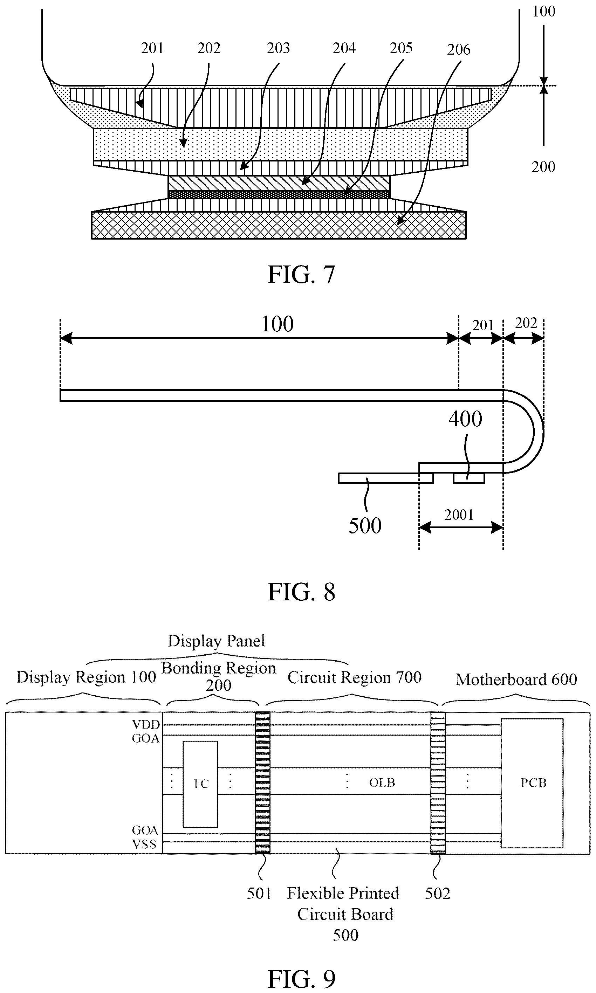

FIG. 7 is a schematic diagram of a structure of a bonding region in a display panel. As shown in FIGS. 6 and 7, in a plane parallel to the display panel, a bonding region 200 is located on one side of the display region 100, and the bonding region 200 includes a first fanout region 201, a bending region 202, and a composite circuit region 2001 arranged in sequence in a direction away from the display region 100. The composite circuit region 2001 may include a second fanout region 203, an anti-static region 204, a drive chip region 205 and a bonding electrode region 206 arranged in sequence in a direction away from the bending region 202. The first fanout region 201 includes data fanout lines located in middle of the first fanout region 201, first power supply lines and second power supply lines. The data fanout lines include multiple data connection lines configured to connect with data lines of the display region 100 in a fanout manner. The first power supply line is configured to connect with high-voltage power supply line (VDD) of the display region 100, and the second power supply line is a low-voltage power supply line (VSS) located in the bezel region 300. The bending region 202 includes a composite insulating layer provided with a groove, and is configured to bend the bonding region 200 to the back of the display region 100. The second fanout region 203 includes multiple data connection lines led out in a fanout trace manner. The anti-static region 204 includes an anti-static circuit configured to prevent electrostatic damage to the display panel by eliminating static electricity. The drive chip region 205 includes an Integrated Circuit (IC) 400 configured to be connected with multiple data connection lines. The bonding electrode region 206 includes multiple Bonding Pads configured to be bonded and connected with a Flexible Printed Circuits (FPC) 500. In an exemplary implementation, the Integrated Circuit (IC) 400 may be bondeded and connected to the driver chip region 205, and the Flexible Printed Circuits (FPC) 500 may be bondeded and connected to the bonding electrode region 206. In an exemplary implementation, the integrated circuit 400 may generate a drive signal required for driving sub-pixels, and may provide the drive signal to the sub-pixels in the display region 100. For example, the drive signal may be a data signal that controls light emitting brightness of the sub-pixel. In an exemplary implementation, the bonding electrode region 206 may be provided with bonding pads containing multiple PINs, and the flexible printed circuits 500 may be bonded and connected to the bonding pads.

In an exemplary implementation, as shown in FIG. 8, the bending region 202 may be bent with a curvature, so that a surface of the composite circuit region 2001 may be turned over, that is, a surface of the composite circuit region 2001 facing upwards may be changed to be facing downwards by the bending of the bending region 202. In an exemplary implementation, when the bending region 202 is bent, the composite circuit region 2001 may be overlapped with the display region 100 in a thickness direction of the display panel.

In an exemplary implementation, as shown in FIG. 9, a flexible printed circuit board (FPC) 500 includes a bonding connection region 501 and a motherboard connection region 502, the FPC is bonded to the bonding region 200 through the bonding connection region 501, and the FPC is connected to the motherboard 600 through the motherboard connection region 502. In an exemplary implementation, the FPC and the motherboard may be connected via a board-to-board (BTB) connector. In an exemplary implementation, a Printed Circuit Board (PCB) may be arranged on the motherboard, and the Flexible Circuit Board 500 may be electrically connected with the PCB on the motherboard 600 through the motherboard connection region 502.

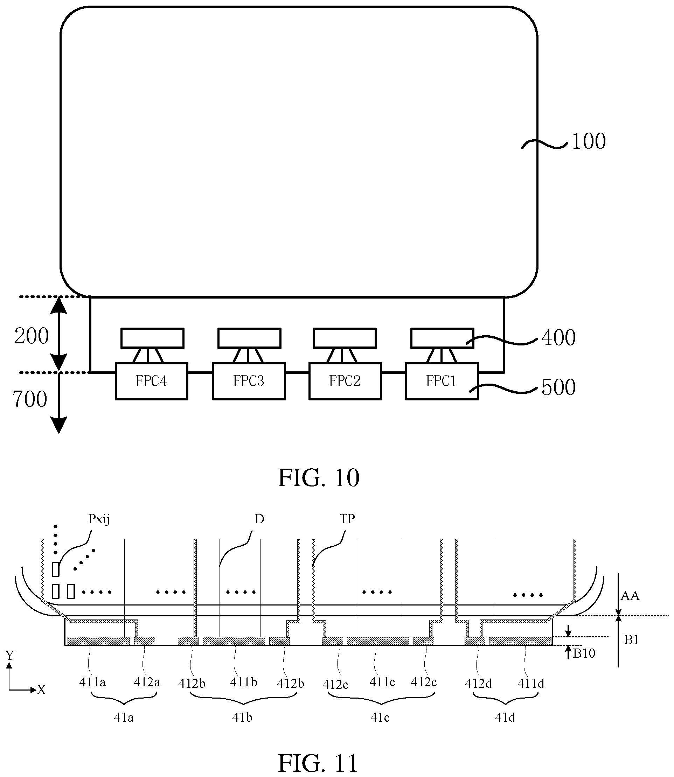

In an exemplary implementation, for a large size display panel, a plurality of ICs and a plurality of FPCs need to be arranged, and the plurality of FPCs are respectively bonded to the plurality of ICs. As shown in FIG. 10, four ICs may be arranged to be respectively bonded to the four FPCs, and the embodiments of the present disclosure are not limited to four ICs and four FPCs. In an embodiment of the present disclosure, the quantity of ICs and FPCs may be arranged according to a size of the display panel as well as functional requirements, and is not limited in the present disclosure.

Typically, the display panel is provided with a plurality of gate drive circuits (GOA) and gate drive circuit signal lines (GOA signal lines), and the GOA signal lines may include clock signal lines (for example, CK signal lines, CB signal lines, STV signal lines, etc.). The plurality of GOA signal lines are arranged on left and right bezels of the display panel as shown in FIGS. 10 and 6, and are connected with the FPCs from the left and right bezels to the lower bezel through bonding pin groups. In a case where the size of the display panel is relatively small, since the quantity of gate drive circuits is relatively small, a quantity of GOA signal lines is relatively small, a plurality of GOA signals are transmitted to the GOA signal lines on left and right sides of the display panel via the PCB board and the FPCs, and a size of the lower bezel of the display panel can accommodate the plurality of GOA signal lines. In an embodiment of the present disclosure, GOA is an abbreviation for Gate Driver on Array.

The FPC is provided with a plurality of gate drive circuit traces (GOA traces), the display panel is provided with a plurality of GOA signal lines and bonding pins connected with the plurality of GOA signal lines, and the plurality of GOA traces on the FPC are respectively bonded and connected with the plurality of bonding pins to realize the respective electrical connections between the GOA traces on the FPC and the plurality of GOA signal lines in the display panel. At present, the quantity of GOA signal lines in the display panel increases due to many factors, one of which is that with the increase of the size of the display panel, the GOA (gate drive circuit) traces on the FPC and the GOA signal lines in the display panel also increase.

When the quantity of GOA signal lines in the display panel increases, the gate drive circuit traces on the FPC correspondingly increase, so that dimensions of the GOA (gate drive circuit) traces on the display panel and the bonding pins connected with the gate drive circuits in the display panel for the FPC increase along the arrangement direction, resulting in an increase in space occupied by the FPC on the display panel, which has a problem that the space for the display panel to connect with the FPCs is insufficient.

An embodiment of the present disclosure provides a display panel, which includes:

a display substrate, including a display region and a bonding region on one side of the display region;
a plurality of sub-pixels, located in the display region;
a plurality of data lines, located in the display region and electrically connected with the plurality of sub-pixels; and
a plurality of bonding pin groups, located in the bonding region, wherein a bonding pin group includes at least one drive pin group and at least one touch pin group, and in the plurality of bonding pin groups, the plurality of drive pin groups are arranged in a first direction, the at least one touch pin group is interspersed in the plurality of drive pin groups, and at least one touch pin group is arranged between two adjacent drive pin groups, at least part of drive pins of the drive pin groups is configured to be electrically connected with the plurality of data lines, and the at least one touch pin group is configured to be electrically connected with the touch line.

In a display panel provided in an embodiment of the disclosure, at least one touch pin group is interspersed in the plurality of drive pin groups, the at least one touch pin group is arranged between two adjacent drive pin groups, and the touch pin group is arranged at a middle position of the plurality of bonding pin groups, so that the gaps between the plurality of bonding pin groups can be fully utilized, spaces occupied by flexible circuit boards on the display panel are saved to a great extent, and the problem that the space for the display panel to connect with FPCs in the existing art is insufficient is overcome.

As shown in FIG. 11, an embodiment of the present disclosure provides a display panel that may include:

a display substrate, including a display region AA and a bonding region B1 on one side of the display region AA;
a plurality of sub-pixels Pxij, located in the display region AA;
a plurality of data lines, located in the display region AA and electrically connected with the plurality of sub-pixels Pxij;
a plurality of bonding pin groups 41, located in the bonding region B1, wherein a bonding pin group 41 includes at least one drive pin group 411 and at least one touch pin group 412, and in the plurality of bonding pin groups 41, the plurality of drive pin groups 411 are arranged in a first direction X, the at least one touch pin group 412 is interspersed in the plurality of drive pin groups 411, and the at least one touch pin group 412 is arranged between two adjacent drive pin groups 411, at least part of drive pins of the drive pin groups 411 is configured to be electrically connected with a plurality of data lines, and the at least one touch pin group 412 is configured to be electrically connected with a touch line TP.

In an exemplary implementation, a plurality of drive pins may be included in a drive pin group 411.

In an exemplary implementation, the plurality of data lines includes at least a plurality of data signal lines D which may be configured to provide data signals to the plurality of sub-pixels Pxij.

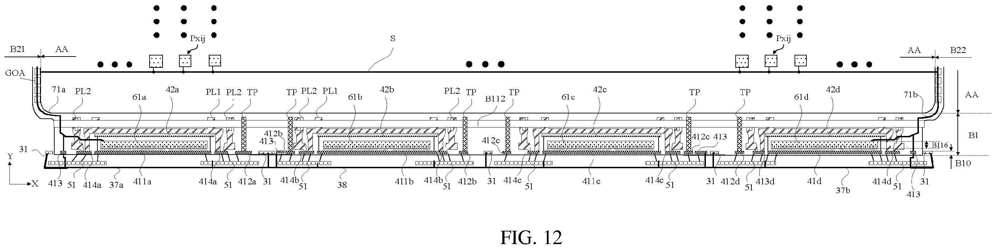

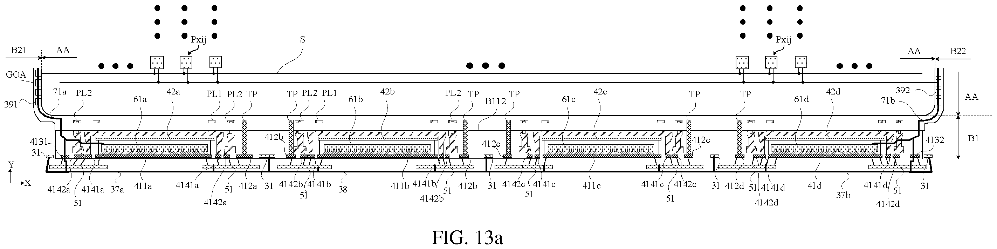

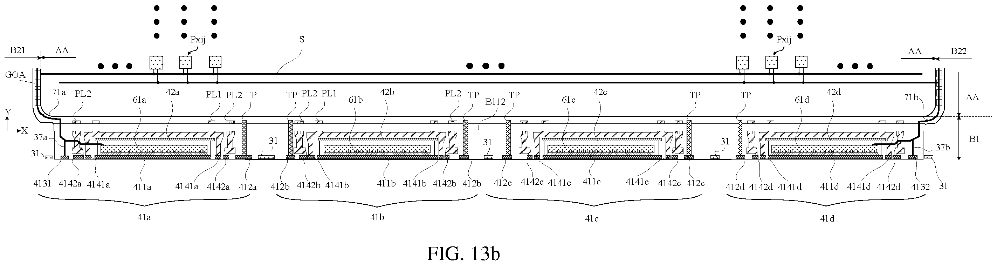

In an exemplary implementation, as shown in FIGS. 12, 13a, and 13b, the display substrate may further include: a bezel region surrounding the display region AA, the bezel region includes a bonding region B1, and the bezel region is provided with gate drive circuits GOAs.

At least two bonding pin groups 41 of the plurality of bonding pin groups 41 each include a gate drive circuit pin group 413 configured to be electrically connected with a gate drive circuit.

In an exemplary implementation, as shown in FIGS. 13a and 13b, a quantity of at least two bonding pin groups is two, the two bonding pin groups each includes a gate drive circuit pin group 413, and the two gate drive circuit pin groups 413 are respectively located in two bonding pin groups 41 on two sides in the first direction X.

In an exemplary implementation, the plurality of bonding pin groups 41 include n bonding pin groups 41, a first bonding pin group 41 to an nth bonding pin group 41 are arranged in sequence in the first direction X, where n is a positive integer greater than or equal to 2; as shown in FIGS. 13a and 13b, n may be 4.

The two gate drive circuit pin groups 413 include a first gate drive circuit pin group 4131 located in the first bonding pin group 41 and a second gate drive circuit pin group 4132 located in the nth bonding pin group 41.

In the first bonding pin group 41, the first gate drive circuit pin group 4131 is located on a side of a drive pin group 411 away from the nth bonding pin group 41, and the first gate drive circuit pin group 4131 and a touch pin group 412 are located on two sides of the drive pin group 411, respectively. In the nth bonding pin group 41, the second gate drive circuit pin group 4132 is located on a side of the drive pin group 411 away from the first bonding pin group 41, and the second gate drive circuit pin group 4132 and a touch pin group 412 are located on two sides of the drive pin group 411, respectively.

As shown in FIGS. 13a and 13b, the plurality of bonding pin groups 41 may include a first bonding pin group 41a, a second bonding pin group 41b, a third bonding pin group 41c, and a fourth bonding pin group 41d arranged in the first direction X. The first bonding pin group 41a, the second bonding pin group 41b, the third bonding pin group 41c, and the fourth bonding pin group 41d each include a drive pin group 411a, a drive pin group 411b, a drive pin group 411c, a drive pin group 411d. A first gate drive circuit pin group 4131 is located in the first bonding pin group 41a, and a second gate drive circuit pin group 4132 is located in the fourth bonding pin group 41d. In the first bonding pin group 41a, the first gate drive circuit pin group 4131 is located on a side of the drive pin group 411a away from the fourth bonding pin group 41d, and the first gate drive circuit pin group 4131 and a touch pin group 412a are located on two sides of the drive pin group 411a, respectively. In the fourth bonding pin group 41d, the second gate drive circuit pin group 4132 is located on a side of the drive pin group 411d away from the first bonding pin group 41a, and the second gate drive circuit pin group 4132 and a touch pin group 412d are located on two sides of the drive pin group 411d, respectively.

In an exemplary implementation, as shown in FIGS. 12 to 13b, a bonding pin group 41 also includes two power supply pin groups 414 configured to be electrically connected with power supply lines.

In the first direction X, in a same bonding pin group 41, two power supply pin groups 414 are respectively arranged on two sides of a drive pin group 411, a power supply pin group 414 and a touch pin group 412 on a same side of the drive pin group 411 are arranged in the first direction X, and a power supply pin group 414 and a gate drive circuit pin group 413 on a same side of the drive pin group 411 are arranged in the first direction X.

In an exemplary implementation, as shown in FIGS. 13a and 13b, in a same bonding pin group 41, in the first direction X, the power supply pin group 414 located on a same side of a drive pin group 411 includes a first power supply pin group 4141 and a second power supply pin group 4142, the second power supply pin group 4142 is located on a side of the first power supply pin group 4141 away from the drive pin group 411, the first power supply pin group 4141 is configured to be electrically connected with a first power supply line PL1, and the second power supply pin group 4142 is configured to be electrically connected with a second power supply line PL2.

In an exemplary implementation, as shown in FIGS. 13a to 15, in a same bonding pin group 41, in the first direction X, two first power supply pin groups 4141 located on two sides of a drive pin group 411 are symmetrical with respect to the drive pin group 411, and two second power supply pin groups 4142 located on two sides of the drive pin group 411 are symmetrical with respect to the drive pin group 411.

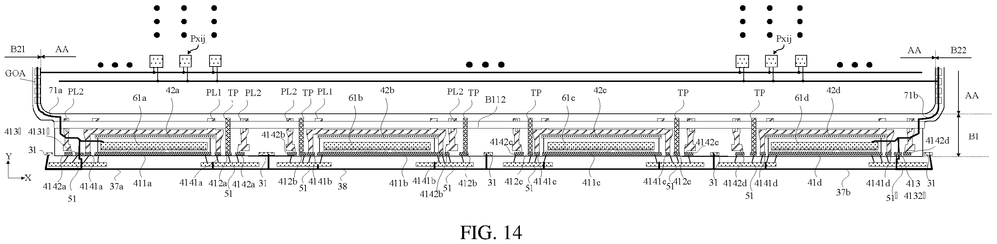

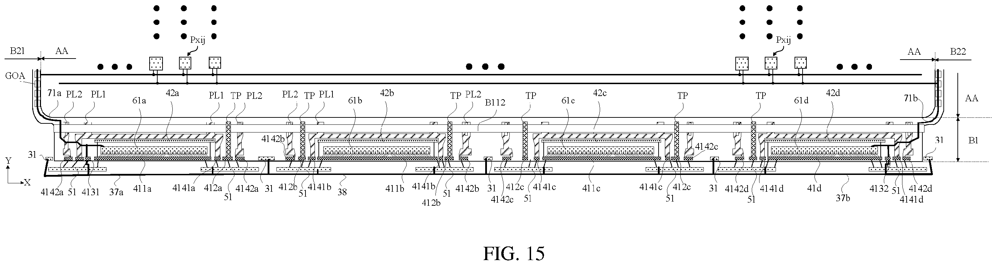

In an exemplary implementation, as shown in FIGS. 13a and 13b, in the first bonding pin group 41, in the first direction X, and on a side of the drive pin group 411 away from an nth bonding pin group 41, a first gate drive circuit pin group 4131 is located on a side of a second power supply pin group 4142 away from a first power supply pin group 4141, or as shown in FIG. 14, the first gate drive circuit pin group 413 is located between the first power supply pin group 4141 and the second power supply pin group 4142, or as shown in FIG. 15, the first gate drive circuit pin group 4131 is located between the first power supply pin group 4141a and the drive pin group 411a.

As shown in FIGS. 13a and 13b, in the nth bonding pin group 41, in the first direction X, and on a side of the drive pin group 411 away from the first bonding pin group 41, a second gate drive circuit pin group 4132 is located on a side of a second power supply pin group 4142 away from a first power supply pin group 4141, or as shown in FIG. 14, the second gate drive circuit pin group 4132 is located between the first power supply pin group 4141 and the second power supply pin group 4142, or as shown in FIG. 15, the second gate drive circuit pin group 4132 is located between the first power supply pin group 4141 and the drive pin group 411.

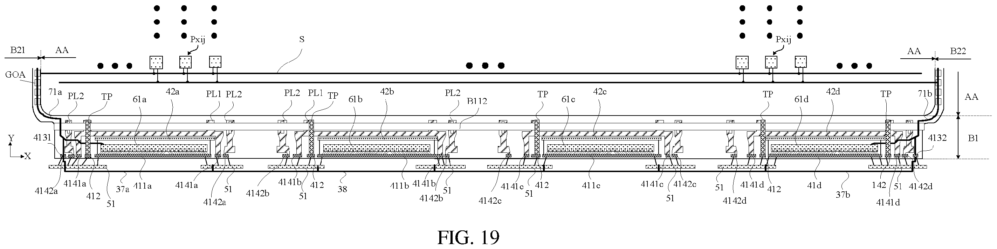

In an exemplary implementation, as shown in FIGS. 12 to 15, in a same bonding pin group 41, in the first direction X, a power supply pin group 414 and a touch pin group 412 located on a same side of a drive pin group 411 are arranged in the first direction X, and, as shown in FIGS. 12 to 13b, the touch pin group 412 is located on a side of a second power supply pin group 4142 away from a first power supply pin group 4141, or as shown in FIG. 14, the touch pin group 412 is located between the first power supply pin group 4141 and the second power supply pin group 4142, or as shown in FIG. 19, the touch pin group 412 is located between the drive pin group 411 and the first power supply pin group 4141.

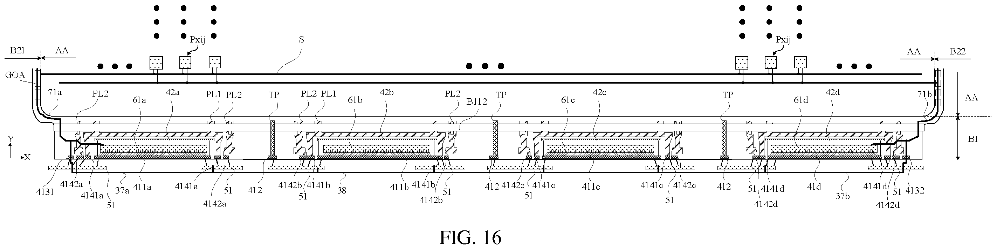

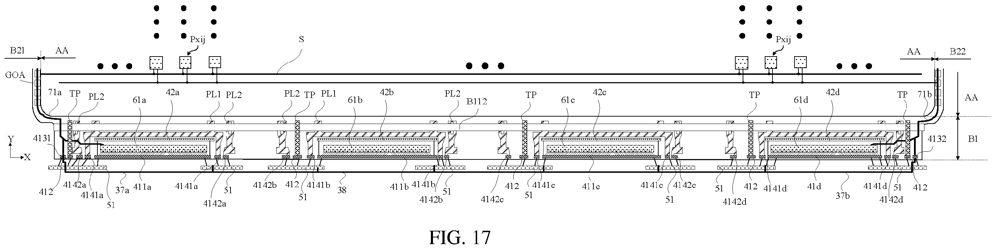

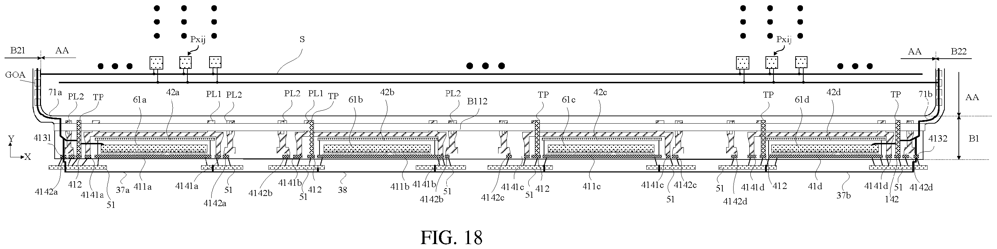

In an exemplary implementation, as shown in FIGS. 16 to 18, a touch pin group 412 is arranged between two adjacent drive pin groups, and as shown in FIG. 16, the touch pin group 412 may be located between two second power supply pin groups 4142, or as shown in FIG. 17, the touch pin group 412 may be located between a first power supply pin group 4141 and a second power supply pin group 4142 in a same bonding pin group 41, or as shown in FIG. 18, the touch pin group 412 may be located between the first power supply pin group 4141 and a drive pin group 411 in the same bonding pin group 41.

In an exemplary implementation, in the first direction X, at least one touch pin group 412 is arranged on a side of a first bonding pin group 41 away from an nth bonding pin group 41. On the side of the first bonding pin group away from the nth bonding pin group, as shown in FIG. 17, the at least one touch pin group 412 is located between a first gate drive circuit pin group 4131 and a second power supply pin group 4142, or as shown in FIG. 18, the at least one touch pin group 412 is located between the first power supply pin group 4141 and the second power supply pin group 4142, or as shown in FIG. 19, the at least one touch pin group 412 is located between the first power supply pin group 4141 and a drive pin group 411.

At least one touch pin group is arranged on a side of the nth bonding pin group 41 away from the first bonding pin group 41. On the side of the nth bonding pin group away from the first bonding pin group, as shown in FIG. 17, the at least one touch pin group 412 is located between a second gate drive circuit pin group 4132 and the second power supply pin group 4142, or as shown in FIG. 18, the at least one touch pin group 412 is located between the first power supply pin group 4141 and the second power supply pin group 4142, or as shown in FIG. 19, the at least one touch pin group 412 is located between the first power supply pin group 4141 and the drive pin group 411.

In an exemplary implementation, as shown in FIG. 12, a bonding region B1 may include a bonding pin region B10 and a drive chip region B116, the drive chip region B116 is located between the display region AA and the bonding pin region B10 in a second direction Y, and a plurality of bonding pin groups 41 are arranged in the bonding pin region B116.

The driver chip region B116 is provided with a plurality of integrated circuit pin groups 61 arranged in the first direction X, the plurality of integrated circuit pin groups 61 are configured to be bonded to integrated circuits and electrically connected to a plurality of data lines, and a plurality of drive pin groups 411 are respectively connected to a corresponding plurality of integrated circuit pin groups 61 through pin connection lines; and the plurality of bonding pin groups 41 are configured to be electrically connected with the plurality of data lines through the plurality of integrated circuit pin groups 61 respectively.

In an exemplary implementation, as shown in FIGS. 12 to 15, the plurality of integrated circuit pin groups include n integrated circuit pin groups, a first integrated circuit pin group 61 to an nth integrated circuit pin group 61 are arranged in sequence in the first direction X, and are connected with a first bonding pin group 41 to an nth bonding pin group 41, respectively; gate drive circuits GOAs are configured to be electrically connected with the first integrated circuit pin group 61 and the nth integrated circuit pin group 61 through gate drive circuit signal lines.

In an exemplary implementation, as shown in FIGS. 12 to 15, a bezel region includes a first bezel region B21 and a second bezel region B22 located on two sides of the display region AA in the first direction X; the gate drive circuit signal line includes a first gate drive circuit signal line 71a extending from the first bezel region B21 to the bonding region B1, and a second gate drive circuit signal line 71b extending from the second bezel region B22 to the bonding region B1.

The gate drive circuit GOA includes a first gate drive circuit arranged in the first bezel region B21 and a second gate drive circuit arranged in the second bezel region B22. The first gate drive circuit is configured to be electrically connected with a first integrated circuit pin group 61a through the first gate drive circuit signal line 71a, and the second gate drive circuit is configured to be electrically connected with an nth integrated circuit pin group 61 through the second gate drive circuit signal line 71b.

In FIGS. 12 to 15, n may be 4, and the integrated circuit pin groups may include an integrated circuit pin group 61a, an integrated circuit pin group 61b, an integrated circuit pin group 61c, and an integrated circuit pin group 61d.

In an exemplary implementation, as shown in FIGS. 12 to 15, the bonding region B1 may also be provided with a first adapter line 37a and a second adapter line 37b, the first adapter line 37a is configured to be connected with the first gate drive circuit signal line 71a and a first gate drive circuit pin group 4131, and the second adapter line 37b is configured to be connected with the second gate drive circuit signal line 71b and a second gate drive circuit pin group 4132.

In an exemplary implementation, as shown in FIGS. 12 to 15, the display panel may further include a plurality of test circuit groups 42 located in the bonding region B1 and arranged in the first direction X. In the second direction Y, the plurality of test circuit groups 42 are located between the plurality of bonding pin groups 41 and the display region AA; the plurality of test circuit groups 42 are electrically connected with the plurality of data lines, and each test circuit group 42 is configured to be connected with at least one bonding pin group 41 during a test phase. The plurality of test circuit groups 42 may include a first test circuit group 42a, a second test circuit group 42b, a third test circuit group 42c and a fourth test circuit group.

In an exemplary implementation, the first direction X intersects the second direction Y in a plane in which the display substrate is located. In an exemplary implementation, the first direction X is perpendicular to the second direction Y in the plane in which the display substrate is located.

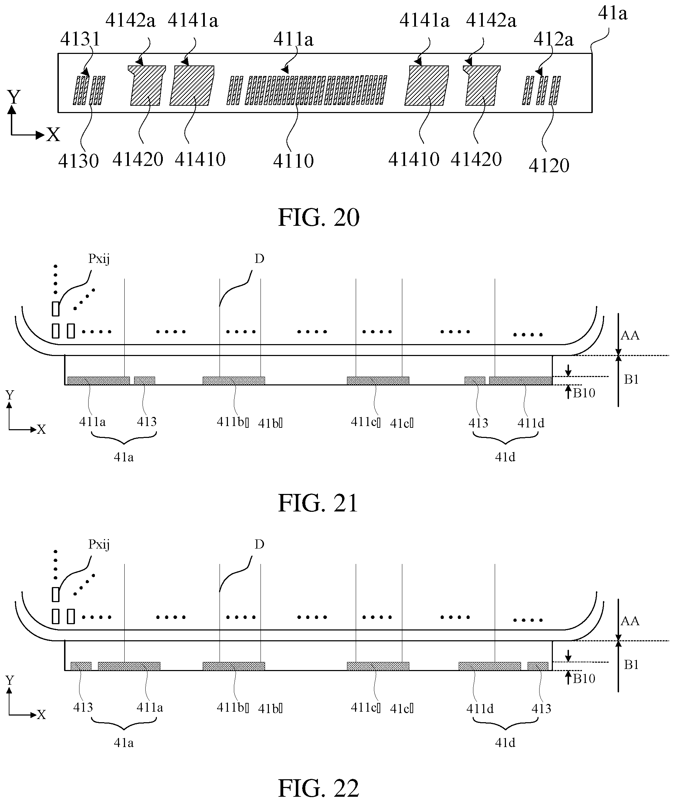

As shown in FIG. 20, FIG. 20 is an enlarged schematic diagram of a structure of a first bonding pin group 41a in FIGS. 13a and 13b. In the first bonding pin group 41, power supply pin groups 414 (including a first power supply pin group 4141 and a second power supply pin group 4142) are located on two sides of a drive pin group 411a, a first gate drive circuit 391 pin group 4131 is located on one side of the drive pin group 411a away from a fourth drive pin group 41d, and the power supply pin groups 414 (including the first power supply pin group 4141 and the second power supply pin group 4142) are located between the first gate drive circuit 391 pin group 4131 and the drive pin group 411a, and a touch pin group 412a is located between the drive pin group 411a and a second bonding pin group 41b. In the first direction X, a first power supply pin group 4141a and a second power supply pin group 4142a are included on a same side of the drive pin group 411a, and the first power supply pin group 4141a is located between the drive pin group 411a and the second power supply pin group 4142a. As shown in FIG. 20, the drive pin group 411a may include a plurality of drive pins 4110 arranged in the first direction, the touch pin group 412a may include a plurality of touch pins 4120 arranged in the first direction X, the first gate drive circuit 391 pin group 4131 may include a plurality of gate drive circuit pins 4130 arranged in the first direction X, the first power supply pin group 4141a may include at least one first power supply pin 41410, the second power supply pin group 4142a may include at least one second power supply pin 41420, the first power supply pin 41410 is configured to be connected with the first power supply line PL1, and the second power supply pin 41420 is configured to be connected with a second power supply line PL2.

In the embodiment of the present disclosure, as shown in FIGS. 12 to 15, the value of the above n may be 4, the bonding region B1 may include a first bonding pin group 41a, a second bonding pin group 41b, a third bonding pin group 41c, and a fourth bonding pin group 41d, and correspondingly the drive pin groups 411 may include a first drive pin group 411a, a second drive pin group 411b, a third drive pin group 411c, and a fourth drive pin group 411d. First power supply pin groups 4141 may include a first first power supply pin group 4141a, a second first power supply pin group 4141b, a third first power supply pin group 4141c, and a fourth first power supply pin group 4141d. Second power supply pin groups 4142 may include a first second power supply pin group 4142a, a second second power supply pin group 4142b, a third second power supply pin group 4142c, and a fourth second power supply pin group 4142d. Touch pin groups 412 may include a first touch pin group 412a, a second touch pin group 412b, a third touch pin group 412c, and a fourth touch pin group 412d.

An embodiment of the present disclosure also provides a display panel, as shown in FIGS. 21 and 22, including:

a display substrate, including a display region AA and a bonding region B1 on one side of the display region AA;
a plurality of sub-pixels Pxij, located in the display region AA;
a plurality of data lines, located in the display region AA and electrically connected with the plurality of sub-pixels Pxij;
a plurality of bonding pin groups 41, located in the bonding region B1, wherein a bonding pin group 41 includes at least one drive pin group 411, and in the plurality of bonding pin groups 41, a plurality of drive pin groups 411 are arranged in a first direction X, two bonding pin groups 41 located on two sides of the plurality of bonding pin groups 41 each includes a gate drive circuit pin group 413, at least part of drive pins of the drive pin groups 411 is configured to be electrically connected with the plurality of data lines, and the gate drive circuit pin group 413 is configured to be electrically connected with gate drive circuit signal lines.

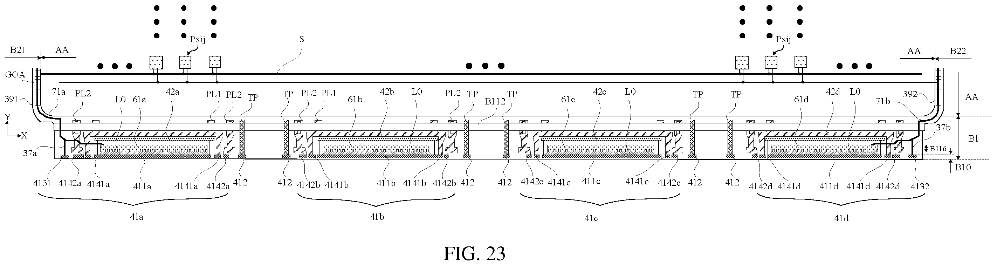

In an exemplary implementation, as shown in FIG. 23, the plurality of bonding pin groups 41 may include n bonding pin groups 41, a first bonding pin group 41 to an nth bonding pin group 41 are arranged sequentially in the first direction X, n being a positive integer greater than or equal to 2. A bonding pin group may also include at least one touch pin group 412 interspersed in n drive pin groups 411, at least one touch pin group 412 is arranged between two adjacent drive pin groups 411, and the at least one touch pin group 412 is configured to be electrically connected with a touch line TP; and a value of n may be 4.

The two gate drive circuit pin groups 413 may include a first gate drive circuit pin group 4131 in a first bonding pin group 41 and a second gate drive circuit pin group 4132 in an nth bonding pin group 41.

In the first bonding pin group 41, the first gate drive circuit pin group 4131 is located on a side of the drive pin group 411 away from the nth bonding pin group 41; in the nth bonding pin group 41, the second gate drive circuit pin group 4132 is located on a side of the drive pin group 411 away from the first bonding pin group 41.

In an exemplary implementation, as shown in FIG. 23, in the first direction X, a touch pin group is not provided on a side of the first gate drive circuit pin group 4131 away from the nth bonding pin group 41; and a touch pin group is not provided on a side of the second gate drive circuit pin group 4132 away from the first bonding pin group 41.

In an exemplary implementation, as shown in FIG. 23, the bonding region B1 includes a bonding pin region B10 and a drive chip region B116, wherein the drive chip region B116 is located between the display region AA and the bonding pin region B10 in a second direction Y, and a plurality of bonding pin groups 41 are arranged in the bonding pin region B10.

The driver chip region B116 is provided with n integrated circuit pin groups 61 arranged in the first direction X. A first integrated circuit pin group 61 to an nth integrated circuit pin group 61 are arranged in sequence in the first direction X, and respectively connected with the first bonding pin group 41 to the nth bonding pin group 41. The n integrated circuit pin groups 61 are configured to be respectively bonded to n integrated circuits and electrically connected with the plurality of data lines, and n drive pin groups 411 are respectively connected with corresponding n integrated circuit pin groups 61 through pin connection lines L0. The n bonding pin groups 41 are configured to be electrically connected with the plurality of data lines through the n integrated circuit pin groups 61 respectively.

In an exemplary implementation, as shown in FIG. 23, the display substrate may further include: a bezel region surrounding the display region AA. The bezel region includes a bonding region B1, and a first bezel region B21 and a second bezel region B22 located on two sides of the display region AA in the first direction X. Gate drive circuits and gate drive circuit signal lines are arranged in the bezel region. The gate drive circuit signal lines may include a first gate drive circuit signal line 71a extending from the first bezel region B21 to the bonding region B1, and a second gate drive circuit 392 signal line 71b extending from the second bezel region B22 to the bonding region B1.

The gate drive circuits GOAs may include a first gate drive circuit 391 arranged in the first bezel region B21, and a second gate drive circuit 392 arranged in the second bezel region B22. The first gate drive circuit 391 is configured to be electrically connected with the first integrated circuit pin group 61 through the first gate drive circuit signal line 71a, and the second gate drive circuits 392 are configured to be electrically connected with the nth integrated circuit pin group 61 through the second gate drive circuit signal line 71b.

In an exemplary implementation, as shown in FIG. 23, the bonding region B1 is further provided with a first adapter line 37a and a second adapter line 37b, the first adapter line 37a is configured to be connected with the first gate drive circuit signal line 71a and the first gate drive circuit pin group 4131, and the second adapter line 37b is configured to be connected with the second gate drive circuit signal line 71b and the second gate drive circuit pin group 4132.

In an exemplary implementation, a bonding pin group 41 also includes two power supply pin groups 414 configured to be electrically connected with power supply lines.

In the first direction X, in a same bonding pin group 41, two power supply pin groups 414 are respectively arranged on two sides of a drive pin group 411, and the power supply pin group 414 and the gate drive circuit pin group 413 on a same side of the drive pin group 411 are arranged in the first direction X.

In an exemplary implementation, in a same bonding pin group 41, in the first direction X, power supply pin groups 414 located on a same side of the drive pin group 411 include a first power supply pin group 4141 and a second power supply pin group 4142. The second power supply pin group 4142 is located on a side of the first power supply pin group 4141 away from the drive pin group 411, the first power supply pin group 4141 is configured to be electrically connected with a first power supply line PL1, and the second power supply pin group 4142 is configured to be electrically connected with a second power supply line PL2.

In an exemplary implementation, as shown in FIGS. 13a, 13b and 23, in the first bonding pin group 41, in the first direction X, on a side of the drive pin group 411 away from the nth bonding pin group 41, the first gate drive circuit pin group 4131 is located on a side of the second power supply pin group 4142 away from the first power supply pin group 4141, or as shown in FIG. 14, the first gate drive circuit pin group 413 is located between the first power supply pin group 4141 and the second power supply pin group 4142, or as shown in FIG. 15, the first gate drive circuit pin group 4131 is located between the first power supply pin group 4141a and the drive pin group 411a.

As shown in FIGS. 13a and 13b, in the nth bonding pin group 41, in the first direction X, on a side of the drive pin group 411 away from the first bonding pin group 41, the second gate drive circuit pin group 4132 is located on a side of the second power supply pin group 4142 away from the first power supply pin group 4141, or as shown in FIG. 14, the second gate drive circuit pin group 4132 is located between the first power supply pin group 4141 and the second power supply pin group 4142, or as shown in FIG. 15, the second gate drive circuit pin group 4132 is located between the first power supply pin group 4141 and the drive pin group 411.

In an embodiment of the present disclosure, a bonding pin group 41 may also include a touch pin group 412, and the arrangement of the touch pin group 412 may refer to the above-described embodiments and those shown in FIGS. 12 to 19, and will not be described in detail here.

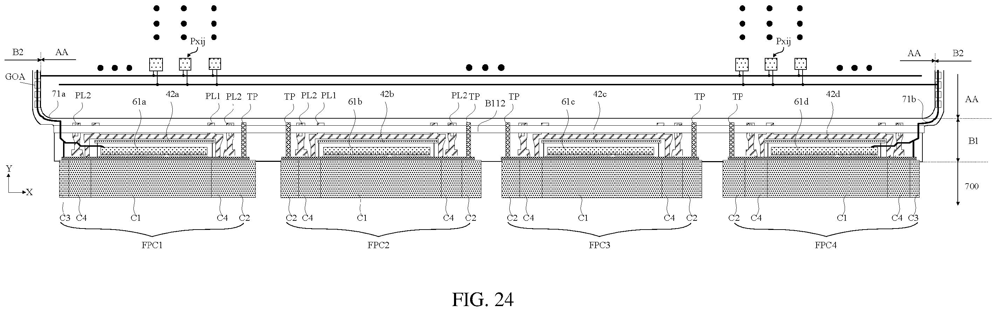

An embodiment of the present disclosure also provides a display panel, which, as shown in FIG. 24, may include:

a display substrate, including a display region AA and a bonding region B1 on one side of the display region AA;
a plurality of sub-pixels Pxij, located in the display region AA;
a plurality of data lines, located in the display region AA and electrically connected with the plurality of sub-pixels Pxij;
a circuit region 700, located on a side of the bonding region B1 away from the display region AA, wherein the circuit region 700 is provided with a plurality of flexible circuit boards arranged in a first direction X, the plurality of flexible circuit boards are arranged to be bonded and connected with the bonding region B1, and a flexible circuit board is provided with at least one drive trace group C1 and at least one touch trace group C2. In the plurality of flexible circuit boards, a plurality of drive trace groups C1 are arranged in the first direction X, at least one touch trace group C2 is interspersed in a plurality of drive trace groups C1, and at least one touch trace group C2 is arranged between two adjacent drive trace groups C1. At least part of the drive track groups C1 is configured to be electrically connected with the plurality of data lines, and at least one touch trace group C2 is configured to be electrically connected with a touch line TP.

In an exemplary implementation, as shown in FIG. 24, the plurality of flexible circuit boards may include n flexible circuit boards, a first flexible circuit board FPC1 to an nth flexible circuit board are arranged in sequence in the first direction X, and n is a positive integer greater than or equal to 2.

The two gate drive circuit trace groups C3 include a first gate drive circuit trace group C31 and a second gate drive circuit trace group C32, wherein the first gate drive circuit lead trace group C31 is located in the first flexible circuit board FPC1, and the second gate drive circuit trace group C32 is located in the nth flexible circuit board.

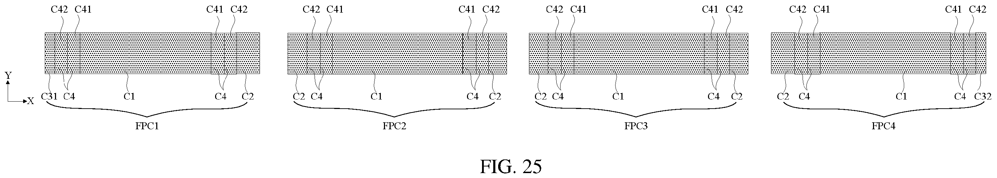

As shown in FIGS. 24 and 25, in a first flexible circuit board FPC1, the first gate drive circuit trace group C31 is located on a side of the drive trace group C1 away from the nth flexible circuit board, and the first gate drive circuit trace group C31 and the touch trace group C2 are located on two sides of the drive trace group C1, respectively; in an nth flexible circuit board, the second gate drive circuit trace group C32 is located on a side of the drive trace group C1 away from the first flexible circuit board FPC1, and the second gate drive circuit trace group C32 and the touch trace group C2 are located on two sides of the drive trace group C1, respectively.

As shown in FIG. 24, a value of n may be 4, and four flexible printed circuit boards may include a first flexible printed circuit board FPC1, a second flexible printed circuit board FPC2, a third flexible printed circuit board FPC3, and a fourth flexible printed circuit board FPC4 arranged in the first direction X.

In an exemplary implementation, any flexible circuit board further includes two power supply trace groups C4.

In the first direction X, as shown in FIG. 24, in a same flexible circuit board, two power supply trace groups C4 are respectively arranged on two sides of the drive trace group C1, a power supply trace group C4 and a touch trace group C2 on a same side of the drive trace group C1 are arranged in the first direction X, and a power supply trace group C4 and a gate drive circuit trace group C3 on a same side of the drive trace group C1 are arranged in the first direction X.

In an exemplary implementation, as shown in FIG. 25, in a same flexible circuit board, in the first direction X, a power supply trace group C4 located on a same side of the drive trace group C1 includes a first power supply trace group C41 and a second power supply trace group C42, and the second power supply trace group C42 is located on a side of the first power supply trace group C41 away from the drive trace group C1.

In an exemplary implementation, as shown in FIG. 25, in a same flexible circuit board, in the first direction X, two first power supply trace groups C41 located on two sides of the drive trace group C1 are symmetrical with respect to the drive trace group C1, and two second power supply trace groups C42 located on two sides of the drive trace group C1 are symmetrical with respect to the drive trace group C1.

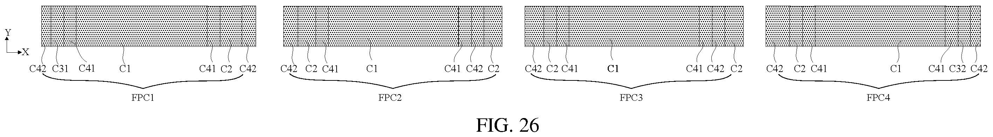

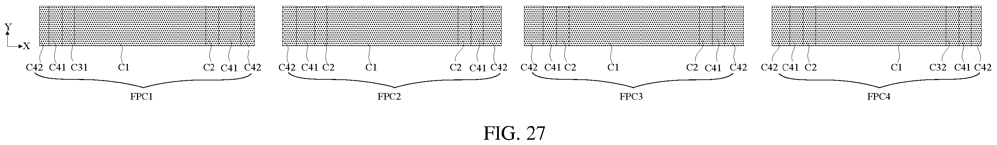

In an exemplary implementation, in the first flexible circuit board FPC1, in the first direction X, on a side of the drive trace group C1 away from the nth flexible circuit board, as shown in FIGS. 24 and 25, the first gate drive circuit trace group C31 is located on a side of a second power supply trace group C42 away from a first power supply trace group C41, or as shown in FIG. 26, the first gate drive circuit trace group C31 is located between a first power supply trace group C41 and a second power supply trace group C42, or as shown in FIG. 27, the first gate drive circuit trace group C31 is located between a first power supply trace group C41 and a drive trace group C1.

In the nth flexible circuit board, in the first direction X, on a side of the drive circuit group C1 away from the first flexible circuit board FPC1, as shown in FIGS. 24 and 25, a second gate drive circuit trace group C32 is located on a side of a second power supply trace group C42 away from a first power supply trace group C41, or as shown in FIG. 26, the second gate drive circuit trace group C32 is located between a first power supply trace group C41 and a second power supply trace group C42, or as shown in FIG. 27, the second gate drive circuit trace group C32 is located between a first power supply trace group C41 and a drive trace group C1.

In an exemplary implementation, in the first direction X, in a same flexible circuit board, a power supply trace group C41 and the touch trace group C2 on a same side of a drive trace group C1 are arranged in the first direction X, and as shown in FIGS. 24 and 25, the touch trace group C2 is located on a side of a second power supply trace group C42 away from a first power supply trace group C41, or as shown in FIG. 26, the touch trace group C2 is located between a first power supply trace group C41 and a second power supply trace group C42, or as shown in FIG. 27, the touch trace group C2 is located between a drive trace group C1 and a first power supply trace group C41.

In an embodiment of the present disclosure, the plurality of flexible printed circuit boards shown in FIG. 25 may be bonded and connected to the display panel in FIG. 13b; the plurality of flexible printed circuit boards shown in FIG. 26 may be bonded and connected to the display panel in FIG. 14; the plurality of flexible printed circuit boards shown in FIG. 27 may be bonded and connected to the display panel in FIG. 15.

In an exemplary implementation, the bezel 300 is arranged around the display region 100, and in the first direction X, the bezel 300 may include a first bezel B21 and a second bezel B22.

In an embodiment of the present disclosure, compared with the existing art, the arrangement of traces of the flexible circuit boards is improved, arrangements of the bonding pin groups in the bonding region B1 in the display panel, the traces of the flexible circuit boards and the signal lines in the display region bezel 300 are adjusted, and the gaps between the bonding pin groups and the plurality of flexible circuit boards are reasonably utilized. In addition, the arrangement of the Outer Lead Bonding (OLB) traces of the flexible circuit boards (i.e., the arrangement of the plurality of drive traces in the drive trace group) is not adjusted, and arrangements of the drive chip and the bonding pads in the bonding region B1 have no need to be not adjusted, so that the drive chips can be avoided from being re-customized due to the adjustment of the drive chips, the cost for replacing the drive chips can be reduced, and the spaces occupied by the flexible circuit boards can be saved at a cost as small as possible.

In the embodiment of the present disclosure, as shown in FIGS. 12 to 13b, the gate drive circuits GOAs may be electrically connected to scan signal lines S of the display region AA, and the plurality of sub-pixels Pxij in the display panel may be driven by one side as shown in FIG. 12, or by two sides as shown in FIGS. 13a and 13b.

In some examples, as shown in FIGS. 12 to 15, in the display substrate, the plurality of test pin groups 51 arranged in the first direction X are also arranged on a side of the bonding region B1 away from the display region AA, and each test pin group may include a plurality of test pins arranged in the first direction X. The test pin is arranged as a pin for signal transmission during a lighting test phase.

In some examples, as shown in FIGS. 12 to 15, the display panel may also include a plurality of aging pins 31 arranged in the first direction X, and the plurality of aging pin groups 31 may be arranged between the plurality of bonding pin groups 41. The aging pin groups 31 may be configured to be used during an aging phase or a test phase. After the aging phase and the test phase are finished and the bonding pin groups are bonded to the flexible printed circuit boards FPCs, the aging pin groups may be retained in the bonding region B1 as invalid pins, as shown in FIG. 13b, which is a schematic diagram of a structure after the test pin groups 51 in FIG. 13a are removed.

In some examples, as shown in FIGS. 12 to 15, in the first direction X, a plurality of aging pin groups 31 may be electrically connected through a second connecting line 38. The second connecting line 38 may include at least a line segment extending in the first direction X and a line segment extending in the second direction Y, wherein the line segment extending in the first direction X may be located on a side of the test pin groups 51 away from the display region AA. In some examples, the second connecting line 38 may be electrically connected with the first and second adapter lines 37a and 37b to ensure signal transmission consistency.

In the structures shown in FIGS. 12 to 15, B 112 is a bending region in the bonding region B 1, and the bending region B112 may be configured so that the bonding region B1 is bent to the back surface of the display region AA.

A display apparatus is also provided in an embodiment of the present disclosure, and the display apparatus may include the display panel according to any one of the aforementioned embodiments. The display apparatus may be any product or component with a display function, such as an OLED display apparatus, a mobile phone, a tablet computer, a television, a display, a notebook computer, a car monitor, a digital photo frame, and a navigator. However, the embodiment is not limited thereto.

In the display panel, the display apparatus provided in embodiments of the present disclosure, at least one touch pin group in the display panel is interspersed in the plurality of drive pin groups, at least one touch pin group is arranged between two adjacent drive pin groups, and the touch pin group is arranged at a middle position of the plurality of bonding pin groups, so that the gaps between a plurality of bonding pin groups can be fully utilized, the spaces occupied by the flexible circuit boards on the display panel is saved to a great extent, and the problem that the spaces for the display panel to connect with FPCs in the existing art is insufficient is overcome.

The drawings of the embodiments of the present disclosure only involve structures involved in the embodiments of the present disclosure, and other structures may refer to a general design.

The embodiments of the present invention, i.e., features in the embodiments, may be combined with each other to obtain new embodiments if there is no conflict.

Although the embodiments disclosed in embodiments of the present disclosure are described as above, the described contents are only the embodiments for facilitating understanding of the present disclosure, which are not intended to limit the present disclosure. Any of those skilled in the art of the present disclosure can make any modifications and variations in the implementation forms and details without departing from the essence and scope of the present disclosure. However, the protection scope of the present disclosure should be subject to the scope defined by the appended claims.

**Claims**

**1.** A display panel, comprising:

a display substrate, comprising a display region and a bonding region located on one side of the display region;
a plurality of sub-pixels, located in the display region;
a plurality of data lines, located in the display region and electrically connected with the plurality of sub-pixels; and
a plurality of bonding pin groups, located in the bonding region, wherein at least one of the plurality of bonding pin groups comprises at least one drive pin group and at least one touch pin group, and in the plurality of bonding pin groups, a plurality of drive pin groups are arranged in a first direction, at least one touch pin group is interspersed in the plurality of drive pin groups, and at least one touch pin group is arranged between two adjacent drive pin groups, at least part of drive pins of the drive pin groups is configured to be electrically connected with the plurality of data lines, and the at least one touch pin group is configured to be electrically connected with a touch line.

2. The display panel according to claim 1, wherein the display substrate further comprises: a bezel region surrounding the display region, and the bezel region comprises the bonding region and is provided with gate drive circuits; at least two of the plurality of bonding pin groups comprise gate drive circuit pin groups, and at least one of the gate drive circuit pin group is configured to be electrically connected with a gate drive circuit.

3. The display panel according to claim 2, wherein a quantity of the at least two bonding pin groups is two, the two bonding pin groups each comprise a gate drive circuit pin group, and in the first direction, two gate drive circuit pin groups are respectively located in the two bonding pin groups on two sides.

4. The display panel according to claim 3, wherein the plurality of bonding pin groups comprise n bonding pin groups, a first bonding pin group to an nth bonding pin group are sequentially arranged in the first direction, and n is a positive integer greater than or equal to 2;

the two gate drive circuit pin groups comprise a first gate drive circuit pin group and a second gate drive circuit pin group, the first gate drive circuit pin group is located in the first bonding pin group, and the second gate drive circuit pin group is located in the nth bonding pin group; in the first bonding pin group, the first gate drive circuit pin group is located on a side of a drive pin group away from the nth bonding pin group, and the first gate drive circuit pin group and a touch pin group are respectively located on two sides of the drive pin group; in the nth bonding pin group, the second gate drive circuit pin group is located on a side of a drive pin group away from the first bonding pin group, and the second gate drive circuit pin group and a touch pin group are respectively located on two sides of the drive pin group.

5. The display panel according to claim 4, wherein the bonding pin group further comprises two power supply pin groups configured to be electrically connected with power supply lines; in the first direction, in a same bonding pin group, the two power supply pin groups are respectively arranged on two sides of the drive pin group, a power supply pin group and a touch pin group on a same side of the drive pin group are arranged in the first direction, and a power supply pin group and a gate drive circuit pin group on a same side of the drive pin group are arranged in the first direction.

6. The display panel according to claim 5, wherein in a same bonding pin group, in the first direction, the power supply pin group located on a same side of the drive pin group comprise a first power supply pin group and a second power supply pin group, the second power supply pin group is located on a side of the first power supply pin group away from the drive pin group, the first power supply pin group is configured to be electrically connected with a first power supply line, and the second power supply pin group is configured to be electrically connected with a second power supply line.

7. The display panel according to claim 6, wherein in a same bonding pin group, in the first direction, two first power supply pin groups located on two sides of the drive pin group are symmetrical with respect to the drive pin group, and two second power supply pin groups located on two sides of the drive pin group are symmetrical with respect to the drive pin group.

8. The display panel according to claim 6, wherein in the first bonding pin group, in the first direction, on a side of the drive pin group away from the nth bonding pin group, the first gate drive circuit pin group is located on a side of the second power supply pin group away from the first power supply pin group, or between the first power supply pin group and the second power supply pin group, or between the first power supply pin group and the drive pin group; in the nth bonding pin group, in the first direction, on a side of the drive pin group away from the first bonding pin group, the second gate drive circuit pin group is located on a side of the second power supply pin group away from the first power supply pin group, or between the first power supply pin group and the second power supply pin group, or between the first power supply pin group and the drive pin group.

9. The display panel according to claim 6, wherein in the first direction, in a same bonding pin group, the power supply pin group and the touch pin group located on a same side of the drive pin group are arranged in the first direction, and the touch pin group is located on a side of the second power supply pin group away from the first power supply pin group, or between the first power supply pin group and the second power supply pin group, or between the drive pin group and the first power supply pin group.

10. The display panel according to claim 6, wherein a touch pin group is arranged between two adjacent drive pin groups, and the touch pin group is located between two second power supply pin groups, or between the first power supply pin group and the second power supply pin group in a same bonding pin group, or between the first power supply pin group and the drive pin group in a same bonding pin group.

11. The display panel according to claim 6, wherein in the first direction, at least one touch pin group is provided on a side of the first bonding pin group away from the nth bonding pin group, and on the side of the first bonding pin group away from the nth bonding pin group, the at least one touch pin group is located between the first gate drive circuit pin group and the second power supply pin group, or between the first power supply pin group and the second power supply pin group, or between the first power supply pin group and the drive pin group;

at least one touch pin group is provided on a side of the nth bonding pin group away from the first bonding pin group; and on the side of the nth bonding pin group from the first bonding pin group, the at least one touch pin group is located between the second gate drive circuit pin group and the second power supply pin group, or between the first power supply pin group and the second power supply pin group, or between the first power supply pin group and the drive pin group.

12. The display panel according to claim 4, wherein the bonding region comprises a bonding pin region and a drive chip region, the drive chip region is located between the display region and the bonding pin region in a second direction, and the plurality of bonding pin groups are arranged in the bonding pin region;

the drive chip region is provided with a plurality of integrated circuit pin groups arranged in the first direction, the plurality of integrated circuit pin groups are configured to be bonded with integrated circuits and electrically connected with the plurality of data lines, and the plurality of drive pin groups are respectively connected with a corresponding plurality of integrated circuit pin groups through pin connection lines; and the plurality of bonding pin groups are configured to be electrically connected with the plurality of data lines through the plurality of integrated circuit pin groups, respectively.

13. The display panel according to claim 12, wherein the plurality of integrated circuit pin groups comprise n integrated circuit pin groups, a first integrated circuit pin group to an nth integrated circuit pin group are sequentially arranged in the first direction and are respectively connected with the first bonding pin group to the nth bonding pin group; and the gate drive circuit is configured to be electrically connected with the first integrated circuit pin group and the nth integrated circuit pin group through gate drive circuit signal lines.

14. The display panel according to claim 13, wherein the bezel region comprises a first bezel region and a second bezel region that are located on two sides of the display region in the first direction; the gate drive circuit signal lines comprise a first gate drive circuit signal line and a second gate drive circuit signal line, the first gate drive circuit signal line extends from the first bezel region to the bonding region, and the second gate drive circuit signal line extends from the second bezel region to the bonding region;

the gate drive circuit comprises a first gate drive circuit arranged in the first bezel region and a second gate drive circuit arranged in the second bezel region, the first gate drive circuit is configured to be electrically connected with the first integrated circuit pin group through the first gate drive circuit signal line, and the second gate drive circuit is configured to be electrically connected with the nth integrated circuit pin group through the second gate drive circuit signal line.

15. The display panel according to claim 14, wherein the bonding region is further provided with a first adapter line and a second adapter line, the first adapter line is configured to be connected to the first gate drive circuit signal line and the first gate drive circuit pin group, and the second adapter line is configured to be connected to the second gate drive circuit signal line and the second gate drive circuit pin group.

16. The display panel according to any one of claims 1 to 15, wherein the bonding region further comprises a plurality of test circuit groups located in the bonding region and arranged in the first direction, and in a second direction, the plurality of test circuit groups are located between the plurality of bonding pin groups and the display region; the plurality of test circuit groups are electrically connected with the plurality of data lines, each test circuit group is configured to be connected with at least one bonding pin group during a test phase; wherein the first direction intersects with the second direction.

17. A display panel, comprising:

a display substrate, comprising a display region, and a bonding region located on one side of the display region;
a plurality of sub-pixels, located in the display region;
a plurality of data lines, located in the display region and electrically connected with the plurality of sub-pixels; and

a plurality of bonding pin groups, located in the bonding region, wherein at least one bonding pin group of the plurality of bonding pin groups comprises at least one drive pin group, and in the plurality of bonding pin groups, a plurality of drive pin groups are arranged in a first direction, two bonding pin groups of the plurality of bonding pin groups located on two sides each comprise a gate drive circuit pin group, at least part of drive pins of the drive pin groups is configured to be electrically connected with the plurality of data lines, and the gate drive circuit pin groups are configured to be electrically connected with gate drive circuit signal lines.

18. The display panel according to claim 17, wherein the plurality of bonding pin groups comprises n bonding pin groups, a first bonding pin group to an nth bonding pin group are sequentially arranged in the first direction, n being a positive integer greater than or equal to 2; a bonding pin group further comprises at least one touch pin group, the at least one touch pin group is interspersed in n drive pin groups, at least one touch pin group is arranged between two adjacent drive pin groups, and the at least one touch pin group is configured to be electrically connected with a touch line;

two gate drive circuit pin groups comprise a first gate drive circuit pin group and a second gate drive circuit pin group, the first gate drive circuit pin group is located in the first bonding pin group, and the second gate drive circuit pin group is located in the nth bonding pin group;
in the first bonding pin group, the first gate drive circuit pin group is located on a side of the drive pin group away from the nth bonding pin group; in the nth bonding pin group, the second gate drive circuit pin group is located on a side of the drive pin group away from the first bonding pin group.

19. The display panel according to claim 18, wherein in the first direction, on a side of the first gate drive circuit pin group away from the nth bonding pin group no touch pin group is provided; on a side of the second gate drive circuit pin group away from the first bonding pin group no touch pin group is provided.

20. The display panel according to claim 18, wherein the bonding region comprises a bonding pin region and a drive chip region, and in a second direction, the drive chip region is located between the display region and the bonding pin region, the plurality of bonding pin groups are provided in the bonding pin region;
the drive chip region is provided with n integrated circuit pin groups arranged in the first direction, a first integrated circuit pin group to an nth integrated circuit pin group are arranged sequentially in the first direction and are respectively connected with the first bonding pin group to the nth bonding pin group, the n integrated circuit pin groups are configured to be respectively bonded with n integrated circuits and electrically connected with the plurality of data lines, and the n drive pin groups are respectively connected with corresponding n integrated circuit pin groups through pin connection lines; the n bonding pin groups are configured to be electrically connected to the plurality of data lines through the n integrated circuit pin groups, respectively.

21. The display panel according to claim 20, wherein the display substrate further comprises:
a bezel region surrounding the display region, the bezel region comprises the bonding region, and a first bezel region and a second bezel region located on two sides of the display region in the first direction, the bezel region is provided with gate drive circuits and gate drive circuit signal lines; a gate drive circuit signal line comprises a first gate drive circuit signal line and a second gate drive circuit signal line, the first gate drive circuit signal line extends from the first bezel region to the bonding region, and the second gate drive circuit signal line extends from the second bezel region to the bonding region;
the gate drive circuit comprises a first gate drive circuit arranged in the first bezel region and a second gate drive circuit arranged in the second bezel region, the first gate drive circuit is configured to be electrically connected with the first integrated circuit pin group through the first gate drive circuit signal line, and the second gate drive circuit is configured to be electrically connected with the nth integrated circuit pin group through the second gate drive circuit signal line.

22. A display apparatus, comprising the display panel according to any one of claims 1 to 16, or the display panel according to any one of claims 17 to 21.

FIG. 1

FIG. 2

302  301  303  304      401      402      403

104 {

103 {

102 {

101      210

## FIG. 3

VDD

C

T5          E

T4          D

N1

S1

N2          T3

T2          N3

S1

T6          E

S2      T1

T7      INIT

INIT

OLED

S1

VSS

## FIG. 4

FIG. 5

FIG. 6

FIG. 7

FIG. 8

FIG. 9

FIG. 10

FIG. 11

FIG. 12

FIG. 13a

FIG. 13b

FIG. 14

FIG. 15

FIG. 16

FIG. 17

FIG. 18

FIG. 19

FIG. 20

FIG. 21

FIG. 22

FIG. 23

FIG. 24

FIG. 25

FPC1

FPC2

FPC3

FPC4

FIG. 26

Y
X

C42 C41 C31    C1          C2 C41 C42    C42 C41 C2    C1        C2 C41 C42    C42 C41 C2    C1         C2 C41 C42    C42 C41 C2    C1     C32 C41 C42

FPC1                          FPC2                            FPC3                            FPC4

FIG. 27

<div align="center">

**INTERNATIONAL SEARCH REPORT**

</div>

| | International application No. |
|---|---|
| | **PCT/CN2023/080321** |

| A. | CLASSIFICATION OF SUBJECT MATTER |
|---|---|

H10K59/131(2023.01)i; H10K59/127(2023.01)i; G06F3/041(2006.01)i

According to International Patent Classification (IPC) or to both national classification and IPC

| B. | FIELDS SEARCHED |
|---|---|

Minimum documentation searched (classification system followed by classification symbols)

IPC: H01L,H10K,G06F

Documentation searched other than minimum documentation to the extent that such documents are included in the fields searched

Electronic data base consulted during the international search (name of data base and, where practicable, search terms used)

CNTXT; ENTXTC; DWPI; CNKI; ENTXT: 显示面板, 驱动, 触控, 绑定, 引脚, display, driv+, touch+, bind+, pin

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 113380864 A (BOE TECHNOLOGY GROUP CO., LTD. et al.) 10 September 2021 (2021-09-10) <br> description, paragraphs 2-109, and figures 1-6 | 1-16, 22 |
| X | CN 109102781 A (WUHAN TIANMA MICROELECTRONICS CO., LTD.) 28 December 2018 (2018-12-28) <br> description, paragraphs 2-71, and figures 1-9 | 17-22 |
| A | CN 109917959 A (SHANGHAI TIANMA MICROELECTRONICS CO., LTD.) 21 June 2019 (2019-06-21) <br> entire document | 1-22 |
| A | CN 110908544 A (AU OPTRONICS CORP.) 24 March 2020 (2020-03-24) <br> entire document | 1-22 |
| A | CN 115004370 A (BOE TECHNOLOGY GROUP CO., LTD. et al.) 02 September 2022 (2022-09-02) <br> entire document | 1-22 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **25 July 2023** | **28 July 2023** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| PCT/CN2023/080321 |

| Patent document cited in search report | | | Publication date (day/month/year) | Patent family member(s) | Publication date (day/month/year) |
|---|---|---|---|---|---|
| CN | 113380864 | A | 10 September 2021 | None | |
| CN | 109102781 | A | 28 December 2018 | None | |
| CN | 109917959 | A | 21 June 2019 | None | |
| CN | 110908544 | A | 24 March 2020 | None | |
| CN | 115004370 | A | 02 September 2022 | None | |

Form PCT/ISA/210 (patent family annex) (July 2022)

**REFERENCES CITED IN THE DESCRIPTION**

**Patent documents cited in the description**

- WO 202211533619X A